# EUROPEAN PATENT APPLICATION

(11) **EP 4 770 339 A2**
(43) Date of publication of application: **01.07.2026**
(21) Application number: 26178045.6
(22) Date of filing: 11.05.2026
(51) Int. Cl.: H10F 10/165, H10F 77/14

(54) **BACK CONTACT CELL AND PHOTOVOLTAIC MODULE**

(30) Priority: 24.03.2026 CN 202610369713; 24.03.2026 CN 202610369642
(71) Applicant: Jinko Solar (Haining) Co., Ltd., Haining, Zhejiang 314415 (CN)
(72) Inventor: Sun, Yufeng, Haining 314415 (CN); Duan, Weiyuan, Haining 314415 (CN); Yang, Jie, Haining 314415 (CN); Zhang, Xinyu, Haining 314415 (CN)
(74) Representative: Schwarz & Partner Patentanwälte GmbH

(57) **Abstract**

A back contact cell (100) includes a substrate (110), a plurality of first passivation contact layers (120), and a plurality of second passivation contact layers (130). The substrate has a first surface (m1), and the first surface defines a plurality of first zones (m11) and a plurality of second zones (m12) that are alternately arranged. The first passivation contact layer (120) includes a tunneling layer (121) and a first doped layer (122). The second passivation contact layer (130) includes an amorphous material layer (131) and a second doped layer (132). The first surface defines a middle region (mz) and two edge regions (mb). On at least one edge region (mb), along the arrangement direction of the first zones (m11) and the second zones (m12), a total size of the first passivation contact layers (120) is greater than a total size of the second passivation contact layers (130) located on the second zones (m12).

## Description

### TECHNICAL FIELD

The present invention relates to the technical field of solar cells, and in particular, to a back contact cell and a photovoltaic module.

### BACKGROUND

Back contact (BC) cell is an apparatus for converting solar energy into electric energy. Specifically, the BC cell generates carriers by utilizing a photovoltaic principle, and then, the carriers are led out by using an electrode, thereby facilitating effective utilization of the electric energy. However, the performances of the BC cell are required to be further improved.

### SUMMARY

According to various embodiments, it is necessary to provide a back contact cell and a photovoltaic module.

In an aspect of the present invention, embodiments of the present invention provide a back contact cell, including a substrate, a plurality of first passivation contact layers, and a plurality of second passivation contact layers. The substrate has a first surface, and the first surface defines a plurality of first zones and a plurality of second zones that are alternately arranged. The first passivation contact layer includes a tunneling layer and a first doped layer, the tunneling layer is provided on the first zone, and the first doped layer is provided on a side of the tunneling layer away from the substrate. The second passivation contact layer includes an amorphous material layer and a second doped layer, the amorphous material layer is at least provided on the second zone, and the second doped layer is provided on a side of the amorphous material layer away from the substrate. Along an arrangement direction of the first zones and the second zones, the first surface defines a middle region and two edge regions located on two sides of the middle region. A part of the first zones and a part of the second zones are located in the middle region, and another part of the first zones and another part of the second zones are located in the edge regions; on at least one edge region, along the arrangement direction of the first zones and the second zones, a total size of the first passivation contact layers is greater than a total size of the second passivation contact layers located on the second zones.

In another aspect of the present invention, embodiments of the present invention provide a photovoltaic module, including a cell string, a packaging layer, and a cover plate. The packaging layer is configured to cover a surface of the cell string. The cover plate is configured to cover a surface of the packaging layer away from the cell string. The cell string is formed by connecting a plurality of back contact cells according to any one of the above embodiments.

### BRIEF DESCRIPTION OF THE DRAWINGS

FIG. 1 is a partial cross-sectional view of a back contact cell according to some embodiments of the present invention;
FIG. 2 is a schematic diagram of an edge region and a middle region of a first surface in some embodiments of the present invention;
FIG. 3A is a schematic diagram of a first passivation contact layer and a second passivation contact layer on a second zone on the edge region in some embodiments of the present invention;
FIG. 3B is a schematic diagram of a first passivation contact layer and a second passivation contact layer on a second zone on the middle region in some embodiments of the present invention;
FIG. 4 is a schematic diagram of the first passivation contact layer and the second passivation contact layer on the second zone on the edge region in some other embodiments of the present invention;
FIG. 5 is a schematic diagram of the first passivation contact layer and the second passivation contact layer on the second zone on the edge region in still other embodiments of the present invention;
FIG. 6 is a schematic diagram of the first passivation contact layer and the second passivation contact layer on the second zone on the edge region in yet other embodiments of the present invention;
FIG. 7 is a schematic diagram of the first passivation contact layer, the second passivation contact layer on the second zone and a first electrode on the edge region in yet other embodiments of the present invention;
FIG. 8 is a schematic diagram of the first passivation contact layer and the second passivation contact layer on the second zone on the edge region in some other embodiments of the present invention;
FIG. 9 is a schematic diagram of the first passivation contact layer, the second passivation contact layer on the second zone and the first electrode on the edge region in some other embodiments of the present invention;
FIG. 10 is a schematic diagram of the first passivation contact layer and the second passivation contact layer on the second zone on the edge region in some other embodiments of the present invention;
FIG. 11 is a schematic diagram of the first passivation contact layer, the second passivation contact layer on the second zone and a second electrode on the edge region in some other embodiments of the present invention;
FIG. 12 is a schematic diagram of the first passivation contact layer and the second passivation contact layer on the second zone on the edge region in some other embodiments of the present invention;
FIG. 13 is a schematic diagram of the first passivation contact layer, the second passivation contact layer on the second zone and the second electrode on the edge region in some other embodiments of the present invention;
FIG. 14 is a schematic diagram of the first passivation contact layer and the second passivation contact layer on the second zone on the edge region in some other embodiments of the present invention;
FIG. 15 is a schematic diagram of the first passivation contact layer, the second passivation contact layer on the second zone, the first electrode and the second electrode on the edge region in some other embodiments of the present invention;
FIG. 16 is a schematic diagram of the first passivation contact layer and the second passivation contact layer on the second zone on the edge region in some other embodiments of the present invention;
FIG. 17 is a schematic diagram of the first passivation contact layer and the second passivation contact layer on the second zone on the edge region in some other embodiments of the present invention;
FIG. 18 is a schematic diagram of the first passivation contact layer and the second passivation contact layer on the second zone on the middle region in some embodiments of the present invention;
FIG. 19 is a schematic diagram of the first passivation contact layer and the second passivation contact layer on the second zone on the middle region in some other embodiments of the present invention;
FIG. 20 is a schematic diagram of the first passivation contact layer and the second passivation contact layer on the second zone on the middle region in still other embodiments of the present invention;
FIG. 21 is a schematic diagram of the first passivation contact layer and the second passivation contact layer on the second zone on the middle region in yet other embodiments of the present invention;
FIG. 22 is a schematic diagram of the first passivation contact layer and the second passivation contact layer on the second zone on the middle region in some other embodiments of the present invention;
FIG. 23 is a schematic diagram of the first passivation contact layer and the second passivation contact layer on the second zone on the middle region in some other embodiments of the present invention;
FIG. 24 is a schematic diagram of a first passivation contact layer and a second passivation contact layer on a second zone on a unit region in some embodiments of the present invention;
FIG. 25 is a schematic diagram of the first passivation contact layer and the second passivation contact layer on the second zone on the unit region in some other embodiments of the present invention;
FIG. 26 is a schematic diagram of cooperation of the unit region and a non-unit region in some other embodiments of the present invention;
FIG. 27 is a schematic diagram of an arrangement of the first electrodes in some embodiments of the present invention;
FIG. 28 is a schematic diagram of an arrangement of the second electrodes in some embodiments of the present invention; and
FIG. 29 is a schematic structural diagram of a photovoltaic module according to some embodiments of the present invention.

### DETAILED DESCRIPTION

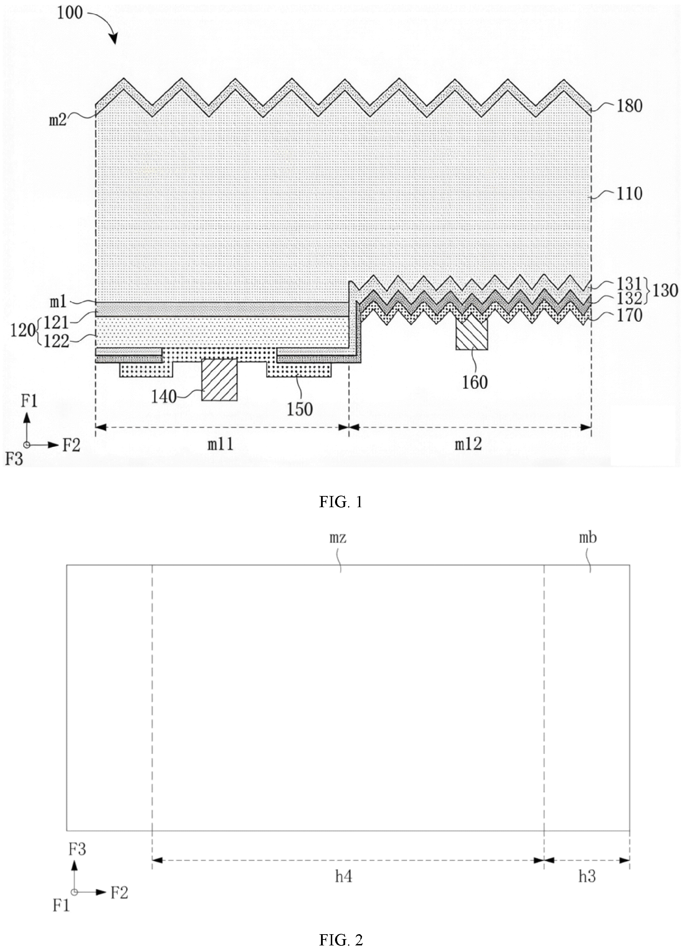

Referring to FIG. 1, which is a partial cross-sectional view of a back contact cell 100 according to some embodiments of the present invention, and some embodiments of the present invention provide a back contact cell 100, including a substrate 110, a plurality of first passivation contact layers 120, and a plurality of second passivation contact layers 130.

The substrate 110 is configured to receive incident light and generate photogenerated carriers. The substrate 110 may be selected according to actual needs. In some embodiments, the substrate 110 may be a silicon substrate, which may include one or more of monocrystalline silicon, polycrystalline silicon, amorphous silicon, and microcrystalline silicon. The doping type of the substrate 110 is not particularly limited. For example, the substrate 110 may be an N-type doped silicon substrate, or may be a P-type doped silicon substrate, which is not limited in particular. An N-type doped element may be group-V elements such as phosphorus (P), bismuth (Bi), antimony (Sb), or arsenic (As); a P-type doped element may be group-III elements such as boron (B), aluminum (Al), gallium (Ga), or indium (In). In the embodiment of the present invention, the substrate 110 may be an N-type monocrystalline silicon wafer, which can improve the conversion efficiency of the back contact cell 100 and reduce the manufacturing cost.

The substrate 110 has a first surface m1, and the first surface m1 defines a plurality of first zones m11 and a plurality of second zones m12 that are arranged alternately.

In some embodiments, referring to FIG. 1, the substrate 110 has the first surface m1 and a second surface m2 that are oppositely arranged. The first surface m1 and the second surface m2 are oppositely arranged in the thickness direction of the substrate 110. The thickness direction of the substrate 110 is a first direction F1 as illustrated in FIG. 1. In some embodiments, taking FIG. 1 as an example, the first surface m1 is a backlight surface, and the second surface m2 is a light receiving surface. It is understood that the light receiving surface and the backlight surface are relative, and the light receiving surface refers to a surface on the substrate in the back contact cell 100 or a photovoltaic module on which sunlight mainly irradiates. The light receiving surface is usually provided with a surface structure, and the surface structure can increase the illumination absorption area, improve the photogenerated current and contribute to improving the efficiency of the cell.

The first zones m11 and the second zones m12 are alternately arranged, that is, along the arrangement direction of the first zones m11 and the second zones m12, an arrangement of "first zone m11, second zone m12, first zone m11, second zone m12, first zone m11,..." or an arrangement of "second zone m12, first zone m11, second zone m12, first zone m11,..." is formed. That is, in the arrangement direction of the first zones m11 and the second zones m12, a zone adjacent to the first zone m11 is the second zone m12 and not another first zone m11; a zone adjacent to the second zone m12 is the first zone m11 and not another second zone m12. It is understood that the initial zone may be the first zone m11 or the second zone m12, and the last zone may be the first zone m11 or the second zone m12, which is not limited herein. In some embodiments, taking FIG. 1 as an example, the arrangement direction of the first zones m11 and the second zones m12 is a second direction F2, and only one first zone m11 and one second zone m12 are illustrated in FIG. 1, without limiting the numbers of both the first zones m11 and the second zones m12.

The first passivation contact layer 120 includes a tunneling layer 121 and a first doped layer 122, the tunneling layer 121 is provided on the first zone m11, and the first doped layer 122 is provided on a side of the tunneling layer 121 away from the substrate 110.

The tunneling layer 121 is configured to achieve the effects of passivating an interface of the first zone m11 of the first surface m1 of the substrate 110, reducing interface state density, and reducing carrier recombination, so as to achieve the effect of chemical passivation. In an embodiment, the interface defect state density of the first zone m11 of the first surface m1 of the substrate 110 is reduced by saturating dangling bonds of the first zone m11 of the first surface m1 of the substrate 110, thereby reducing recombination centers of the first zone m11 of the first surface m1 of the substrate 110 to reduce a carrier recombination rate. The tunneling layer 121 may be a dielectric material layer. For example, the tunneling layer 121 may be made of at least one of silicon oxide, magnesium fluoride, amorphous silicon, polycrystalline silicon, silicon carbide, silicon nitride, silicon oxynitride, aluminum oxide, or titanium oxide. In the embodiment of the present invention, the tunneling layer 121 may be formed by low pressure chemical vapor deposition (LPCVD). Certainly, the tunneling layer 121 may also be formed by other processes such as a thermal oxidation process, a plasma oxidation process, or a nitric acid oxidation process, which is not limited herein.

The conductivity type of a doped element of the first doped layer 122 is adapted to the conductivity type of a doped element of the substrate 110. For example, in the case where the substrate 110 is an N-type substrate, the doped element of the substrate 110 may be phosphorus and/or antimony. The doped element of the first doped layer 122 is phosphorus. For another example, when the substrate 110 is a P-type substrate, the doped element of the first doped layer 122 is boron. In the embodiment of the present invention, the first doped layer 122 is formed by doping amorphous silicon, microcrystalline silicon, polycrystalline silicon, or the like, with an N-type doped element. In some embodiments, the first doped layer 122 is a phosphorus-doped polycrystalline silicon layer. In this case, the stacked tunneling layer 121 and first doped layer 122 together form a passivation contact structure (i.e., the first passivation contact layer 120) that provides good surface passivation for the first zone m11 of the first surface m1 of the substrate 110.

The second passivation contact layer 130 includes an amorphous material layer 131 and a second doped layer 132. The amorphous material layer 131 is at least provided on the second zone m12, and the second doped layer 132 is provided on a side of the amorphous material layer 131 away from the substrate 110.

As a passivation and blocking functional layer, the amorphous material layer 131 is at least provided on the second zone m12, so as to implement interface passivation. The amorphous material layer 131 is at least provided on the second zone m12, which means that the amorphous material layer 131 is provided on the second zone m12, or one part of the amorphous material layer 131 is provided on the second zone m12, and the other part of the amorphous material layer 131 is provided on the first zone m11. In some embodiments, taking FIG. 1 as an example, one part of the amorphous material layer 131 is provided on the second zone m12, and the other part is provided on a side of the first doped layer 122 away from the tunneling layer 121. The amorphous material layer 131 may be a non-dielectric material layer. For example, the non-dielectric material includes amorphous silicon, microcrystalline silicon, nanocrystalline silicon, or the like. In some embodiments, the amorphous material layer 131 may be an intrinsic amorphous silicon layer, an intrinsic microcrystalline silicon layer, an intrinsic silicon oxide layer, or the like, which is not limited herein.

The doping type of the second doped layer 132 is different from the doping type of the first doped layer 122. In some embodiments, the doped element of the first doped layer 122 is an N-type doped element, and the doped element of the second doped layer 132 is a P-type doped element. For example, in the embodiment of the present invention, the second doped layer 132 is formed by doping amorphous silicon, microcrystalline silicon, polycrystalline silicon, or the like, with the P-type doped element. In some embodiments, the second doped layer 132 is a boron-doped amorphous silicon layer.

In some embodiments, the amorphous material layer 131 may be an intrinsic amorphous silicon layer, and the second doped layer 132 may be a doped amorphous silicon layer. The intrinsic amorphous silicon layer has a good surface passivation performance, and can reduce surface recombination at an interface between the second doped layer 132 and the substrate 110, thereby prolonging the service life of charge carriers. In addition, the intrinsic amorphous silicon layer can also be used as a transport medium for electrons and holes, thereby promoting separation and directional movement of electrons and holes near a PN junction, and improving a charge collection efficiency. When the second doped layer 132 is a P-type doped layer, the intrinsic amorphous silicon layer can be used as a barrier for electrons and allows holes to pass through. When the second doped layer 132 is an N-type doped layer, the intrinsic amorphous silicon layer can be used as a barrier for holes and allows electrons to pass through.

It should be noted that, taking the intrinsic amorphous material layer as the amorphous material layer 131 as an example, during the process of manufacturing the second doped layer 132, a small quantity of same doped elements as the second doped layer 132 may be diffused or doped into the amorphous material layer 131 to have a lower doping concentration. In this case, the amorphous material layer 131 is not an intrinsic amorphous material layer in a strict chemical sense, but a lightly doped amorphous material layer, which may also be referred to as a near intrinsic amorphous material layer. That is, the "intrinsic" described in the embodiments of the present invention is a concept with respect to the second doped layer, and is not defined as absolute undoped. The term "intrinsic" in the embodiments of the present invention is used to refer to the situation that doping is not intentionally performed, doping is not performed, or the actual doping amount is quite low (or small), and the influence on the conductivity type and the conductivity property is negligible, and encompasses the intrinsic amorphous material layer, the lightly doped amorphous material layer, and the near intrinsic amorphous material layer.

In some embodiments, taking FIG. 1 as an example, the substrate 110 may be an N-type doped substrate, the tunneling layer 121 may be made of silicon oxide (SiOₓ), the first doped layer 122 may be an N-type doped layer, the amorphous material layer 131 may be an intrinsic amorphous silicon layer, and the second doped layer 132 may be a P-type doped layer. Under the structure, the tunneling layer 121 is configured to pass electrons, and the second doped layer 132 is configured to block electrons and pass holes, so that in the embodiment of the present invention, by combining the high conductivity of the N-type polycrystalline silicon doped layer and the better passivation capability of the P-type amorphous silicon doped layer, transmission of carriers can be balanced, and the photoelectric conversion efficiency of the back contact cell 100 is improved.

Certainly, in practical applications, the design of each layer in the back contact cell 100 is not limited to the above situation. For example, the substrate 110 may be a P-type doped substrate, the first doped layer 122 may be a P-type doped layer, and the second doped layer 132 may be an N-type doped layer. In this case, the tunneling layer 121 serves to pass holes, and the second doped layer 132 serves to block holes and pass electrons. The present invention has no limitations in this respect.

Referring to FIG. 2, which is a schematic diagram of edge regions mb and a middle region mz of the first surface m1. In some embodiments of the present invention, the edge regions mb of the first surface m1 are located on both sides of the middle region mz of the first surface m1 along the arrangement direction of the first zones m11 and the second zones m12. That is, with reference to the arrangement direction of the first zones m11 and the second zones m12, the first surface m1 is divided into the middle region mz and the edge regions mb, the middle region mz is located in the middle of the first surface m1, and the edge regions mb are distributed on both sides of the middle region mz in the arrangement direction. That is, the edge regions mb are located on two opposite sides of the middle region mz, so that a layout in which the middle region mz is centered and the edge regions mb are located on both sides is formed. That is, both sides of the middle region mz of the first surface m1 in the second direction F2 are provided with the edge regions mb. It should be noted that there may be or may not be a boundary between the middle region mz and the edge region mb, which is not limited herein. Taking FIG. 2 as an example, the boundary between the middle region mz and the edge region mb of the first surface m1 is indicated by a dotted line, which only represents the division between the middle region mz and the edge region mb, and is not a limitation on the structure of the first surface m1. The perspective shown in FIG. 2 can be considered as a top view of FIG. 1.

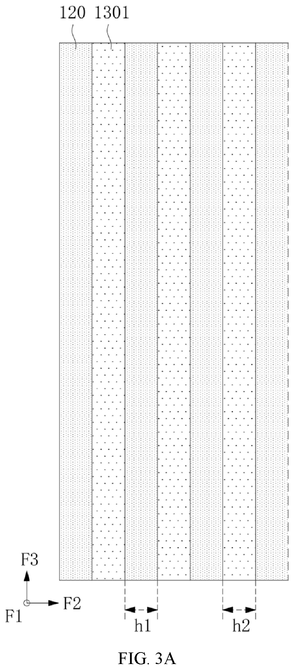

A part of the first zones m11 and a part of the second zones m12 are located in the middle region mz, and the other part of the first zones m11 and the other part of the second zones m12 are located in the edge regions mb. That is, a part of the first zones m11 are located in the middle region mz, the other part of the first zones m11 are located in the edge regions mb, a part of the second zones m12 are located in the middle region mz, and the other part of the second zones m12 are located in the edge regions mb. That is, the number of the first zones m11 located on the edge region mb is plural, and the number of the second zones m12 located on the edge region mb is plural. In some embodiments, taking FIG. 3A as an example, FIG. 3A is a schematic diagram of the first passivation contact layer 120 and the second passivation contact layer 1301 on the second zone m12 on the edge region mb in some embodiments of the present invention, and since the perspective shown in FIG. 3A can be seen as a top view of FIG. 1, the first passivation contact layer 120 is arranged on the first zone m11, the position of the first passivation contact layer 120 can be roughly regarded as the position of the first zone m11, and the second passivation contact layer 130 is at least arranged on the second zone m12, that is, the position of the second passivation contact layer 1301 on the second zone m12 can be roughly regarded as the position of the second zone m12.

It is to be understood that in FIG. 3A, only the second passivation contact layer 1301 located on the second zone m12 is illustrated to more clearly show the relationship of the first zone m11 and the second zone m12. FIG. 3A illustrates the left edge region mb in FIG. 2 The schematic diagrams related to the edge region mb and the middle region mz, which are mentioned later, can be understood with reference to the understanding of FIG. 3A, and are not repeated again.

In some embodiments of the present invention, with continued reference to FIG. 1 to FIG. 3A, on at least one edge region mb, along the arrangement direction of the first zones m11 and the second zones m12, a total size of the first passivation contact layers 120 is greater than a total size of the second passivation contact layers 1301 located on the second zones m12. That is, the aforementioned size control may be adopted on at least one of the two edge regions mb, which is not limited herein.

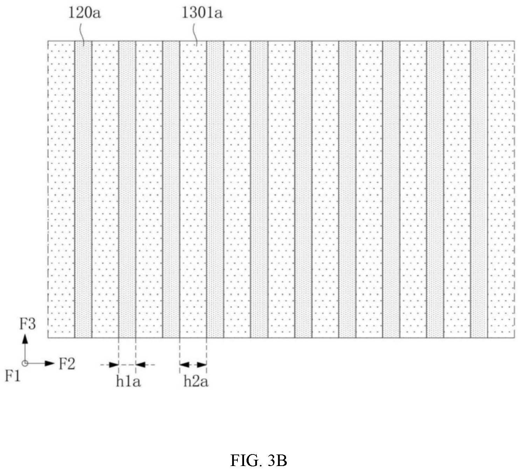

In some embodiments of the present invention, with continued reference to FIG. 2 and FIG. 3B, on the middle region mz, along the arrangement direction of the first zones m11 and the second zones m12, the total size of the first passivation contact layers 120a is less than the total size of the second passivation contact layers 1301a located on the second zones m12.

Taking FIG. 3A as an example, on the edge region mb, the total size of the first passivation contact layers 120 in the arrangement direction of the first zones m11 and the second zones m12 is the sum of the sizes of all the first passivation contact layers 120 in the second direction F2 on the edge region mb. The size of the first passivation contact layer 120 along the second direction F2 is a first size h1, and the first size h1 can be considered as the width of the first passivation contact layer 120. Similarly, on the edge region mb, the total size of the second passivation contact layers 1301 located on the second zones m12 in the arrangement direction of the first zones m11 and the second zones m12 is the sum of the sizes of all the second passivation contact layers 1301 located on the second zones m12 in the second direction F2 on the edge region mb. The size of the second passivation contact layer 1301 located on the second zone m12 along the second direction F2 is a second size h2, and the second size h2 can be considered as the width of the second passivation contact layer 1301 located on the second zone m12. That is, on at least one edge region mb, the total width of the first passivation contact layers 120 is greater than the total width of the second passivation contact layers 1301 located on the second zones m12.

In some embodiments, continuously taking FIG. 3A as an example, with combined reference to FIG. 1, since both the first zone m11 and the second zone m12 extend lengthwise along a third direction F3, both the first zone m11 and the second zone m12 can be regarded as rectangular zones. The size of the first passivation contact layer 120 along the third direction F3 can be regarded as the length of the first passivation contact layer 120, the size of the second passivation contact layer 1301 on the second zone m12 along the third direction F3 can be regarded as the length of the second passivation contact layer 1301 on the second zone m12, and the length of the first passivation contact layer 120 and the length of the second passivation contact layer 1301 on the second zone m12 are substantially the same. In the aforementioned case where "on at least one edge region mb, along the arrangement direction of the first zones m11 and the second zones m12, the total size of the first passivation contact layers 120 is greater than the total size of the second passivation contact layers 1301 located on the second zones m12", the area ratio of the first passivation contact layer 120 is greater than the area ratio of the second passivation contact layer 1301 located on the second zone m12 on the at least one edge region mb.

In some embodiments, the first direction F1, the second direction F2, and the third direction F3 intersect each other. For example, in the embodiment of the present invention, the first direction F1, the second direction F2 and the third direction F3 are perpendicular to each other. In some embodiments, the second direction F2 may be the length direction of the substrate 110, the third direction F3 may be the width direction of the substrate 110, or the second direction F2 may be the width direction of the substrate 110, and the third direction F3 may be the length direction of the substrate 110, which is not limited herein. Certainly, the lengthwise size of the substrate 110 may be greater than or equal to the widthwise size of the substrate 110.

During fabrication of the back contact cell 100, the edge region mb may have structural defects and interface defects such as crystal damage, lattice distortion, dangling bonds, microcracks, notches, impurity enrichment, and a rough and uneven surface, which may form a large number of recombination centers to aggravate the recombination of carriers and shorten the minority carrier lifetime of the edge region mb, and meanwhile may easily cause electric leakage, shunting, and even edge breakdown, thereby reducing the photoelectric conversion efficiency, parallel resistance, and operation stability of the back contact cell 100. By controlling the difference of the widths of the first passivation contact layer 120 and the second passivation contact layer 1301 on the second zone m12 on the at least one edge region mb, the provided second passivation contact layers 130 may be reduced, and the provided first passivation contact layers 120 may be increased. Since the first passivation contact layer 120 does not involve the collection and separation of carriers, and the second passivation contact layer 130 involves the collection and separation of carriers, the field passivation effect at the corresponding edge region mb can be improved by the increased first passivation contact layer 120, and the recombination loss of carriers at the corresponding edge region mb is reduced by the decreased second passivation contact layer 130, which is more beneficial to lowering the risk that the efficiency at the corresponding edge region mb is lowered due to the aforementioned defects, and is beneficial to improving the performance of the back contact cell 100.

In addition, since a part of first zones m11 and a part of second zones m12 are located in the edge region mb, it is beneficial to enlarging an adjustment window for the size of the first passivation contact layer 120 in the arrangement direction of the first zones m11 and the second zones m12 and the size of the second passivation contact layer 1301 on the second zone m12 in the arrangement direction of the first zones m11 and the second zones m12, thereby being more beneficial to more flexibly controlling "the size of the first passivation contact layer 120 in the arrangement direction of the first zones m11 and the second zones m12" and "the size of the second passivation contact layer 1301 on the second zone m12 in the arrangement direction of the first zones m11 and the second zones m12", and then improving the performance of the back contact cell 100.

Thus, since on at least one edge region mb of the first surface m1 of the substrate 110, along the arrangement direction of the first zones m11 and the second zones m12, the total size of the first passivation contact layers 120 is greater than the total size of the second passivation contact layers 1301 on the second zones m12, the total size of the first passivation contact layers 120 on the at least one edge region mb along the arrangement direction of the first zones m11 and the second zones m12 and the total size of the second passivation contact layers 1301 on the second zones m12 along the arrangement direction of the first zones m11 and the second zones m12 are different. Under such structure, by adjusting the size of the first passivation contact layer 120 along the arrangement direction of the first zones m11 and the second zones m12 and the size of the second passivation contact layer 1301 on the second zone m12 along the arrangement direction of the first zones m11 and the second zones m12, and by utilizing the difference between the size of the first passivation contact layer 120 along the arrangement direction of the first zones m11 and the second zones m12 and the size of the second passivation contact layer 1301 on the second zone m12 along the arrangement direction of the first zones m11 and the second zones m12, light energy can be utilized to the maximum extent while the photoelectric conversion efficiency of the back contact cell 100 is considered, which is beneficial to improving the performance of the back contact cell 100.

It should be noted that in some embodiments, the thickness of the first passivation contact layer 120 is greater than the thickness of the second passivation contact layer 130. In some embodiments, the tunneling layer 121 has a thickness of 1nm to 5nm, the first doped layer 122 has a thickness of 30nm to 200nm, the amorphous material layer 131 on the second zone m12 has a thickness of 3nm to 20nm, and the second doped layer 132 on the second zone m12 has a thickness of 10nm to 50nm. For example, the tunneling layer 121 has a thickness of 1nm, the first doped layer 122 has a thickness of 30nm, the amorphous material layer on the second zone m12 has a thickness of 3nm, and the second doped layer 132 on the second zone m12 has a thickness of 10nm. For another example, the tunneling layer 121 has a thickness of 5nm, the first doped layer 122 has a thickness of 200nm, the amorphous material layer 131 on the second zone m12 has a thickness of 20nm, and the second doped layer 132 on the second zone m12 has a thickness of 50nm. As such, the width boundary of the first passivation contact layer 120 and the width boundary of the second passivation contact layer 1301 on the second zone m12 may be determined by an optical or electronic imaging test device, an ellipsometer, or a reflection spectrum measurement method based on the thickness difference. In an embodiment, taking the ellipsometer as an example, when the ellipsometer is used to scan a region to be measured, ellipsometric spectrum signals corresponding to different passivation contact layers may significantly change with different thicknesses. Based on signal discontinuity points caused by the thickness difference, the boundary position between the first passivation contact layer 120 and the second passivation contact layer 1301 located on the second zone m12 may be determined, thereby obtaining width information of the first passivation contact layer 120 and width information of the second passivation contact layer 1301 located on the second zone m12.

In some embodiments, the first zone m11 and the second zone m12 of the first surface m1 of the substrate 110 have a height difference based on the manufacturing manner of the back contact cell 100. In some embodiments, first, an initial first passivation contact layer is fabricated on a first surface of an initial substrate; second, the initial first passivation contact layer on a second zone of the first surface of the initial substrate is removed to form the first passivation contact layer 120; and subsequently, at least the second passivation contact layer 1301 located on the second zone m12 is formed. In this process, the structure having a height difference at the first zone m11 and the second zone m12 of the first surface m1 of the substrate 110 illustrated in FIG. 1, for example, may be formed. In some embodiments, the height difference at the first zone m11 and the second zone m12 of the first surface m1 of the substrate 110 may be 3µm to 10µm. As such, the aforementioned height difference may also be used to determine the width boundary of the first passivation contact layer 120 and the width boundary of the second passivation contact layer 1301 located on the second zone m12. In this process, the first passivation contact layer 120 and the second passivation contact layer 130 may also be determined using an instrument such as an ellipsometer.

It should be further noted that, in the case of having the height difference at the first zone m11 and the second zone m12 of the first surface m1 of the substrate 110, the second zone m12 includes an edge zone configured to be connected to the first zone m11, and the edge zone may be a slope-shaped surface. When the thickness of the second passivation contact layer located on the edge zone of the second zone m12 is measured, an obtained value fluctuates within a range that can be approximately considered as the thickness of the second passivation contact layer located on a middle zone of the second zone m12, and the specific fluctuation range can be determined according to the specific shape of the edge zone.

The above-mentioned total size of the first passivation contact layers 120 on the edge region mb may be obtained by obtaining the width of each first passivation contact layer 120 on the edge region mb based on the determined edge region mb. The total size of the second passivation contact layers 1301 on the second zones m12 on the edge region mb may be understood with reference to the measurement of the total size of the first passivation contact layers 120 on the edge region mb, and is not repeated.

In addition, in some detection methods, for the measurement of the total size, one-by-one detection of all the regions is not required, and only a sampling test is required. Those skilled in the art can reasonably guess and determine the corresponding total size from a measured sample size.

It can be understood that the design and layout of a pattern of the passivation contact layer have regularity. For example, the design parameters on the middle region mz are substantially the same, and the design parameters on the edge region mb are substantially the same. Those skilled in the art can deduce the total size of the whole corresponding region by measuring the size of the sample in the edge region. Similarly, by measuring the size of the sample in the middle region, the total size of the whole corresponding region can be deduced.

It should be noted that, when the back contact cell 100 further includes other layers located on the side of the corresponding passivation contact layer away from the substrate 110, the layers mentioned above may be removed first, and then, the width of the corresponding passivation contact layer is determined.

In some embodiments of the present invention, with continued reference to FIG. 1, the back contact cell 100 further includes a first electrode 140, and the first electrode 140 is arranged on a side of the first doped layer 122 away from the tunneling layer 121 and is electrically connected to the first doped layer 122.

The first electrode 140 is configured to collect and aggregate a current of the back contact cell 100. The first electrode 140 and the first doped layer 122 may be in direct or indirect contact to form the electrical connection. In some embodiments, the first electrode 140 may be manufactured by screen printing and sintering. In some embodiments, metal slurry for manufacturing the first electrode 140 may be made of one or more of aluminum, silver, gold, nickel, molybdenum, and copper, which is not limited herein.

The electrical connection of the first electrode 140 and the first doped layer 122 means that since the material of the first electrode 140 and the material of the first doped layer 122 are both conductive materials, the first electrode 140 and the first doped layer 122 form a physical channel for circulation of photogenerated carriers through direct or indirect physical contact. When the back contact cell 100 is not in a power generation state or a power supply state, the photogenerated carriers are not effectively separated and driven to flow, and the photogenerated carriers do not flow in the physical channel. When the back contact cell 100 is in the power generation state or the power supply state, the first doped layer 122 generates photogenerated carriers, the photogenerated carriers are separated under the action of an electric field built therein, and the photogenerated carriers flow out through the physical channel.

In some embodiments of the present invention, with continued reference to FIG. 1, the back contact cell 100 further includes a first transparent conductive layer 150, and the first transparent conductive layer 150 is provided on the side of the first doped layer 122 away from the tunneling layer 121 and electrically connected to the first doped layer 122. The first electrode 140 is located on the first transparent conductive layer 150.

In some embodiments, the first transparent conductive layer 150 may be made of one or more of indium tin oxide (ITO), aluminum-doped zinc oxide (AZO), indium tungsten oxide (IWO), indium cerium oxide (ICO), and indium zinc oxide (IZO), which is not limited herein.

The arrangement of the first transparent conductive layer 150 is beneficial to reducing the loss of direct transmission of charges from the passivation contact structure to the electrode, increases the output power of the cell, then improves the photoelectric conversion efficiency, and meanwhile can improve the weather resistance of the cell, and prolong the service life.

In some embodiments of the present invention, with continued reference to FIG. 1, the back contact cell 100 further includes a second electrode 160, and the second electrode 160 is arranged on a side of the second doped layer 132 away from the amorphous material layer 131 and is electrically connected to the second doped layer 132. Reference may be made to the first electrode 140 for understanding and implementation of the second electrode 160, which are not repeated herein.

In some embodiments of the present invention, with continued reference to FIG. 1, the back contact cell 100 further includes a second transparent conductive layer 170, and the second transparent conductive layer 170 is provided on the side of the second doped layer 132 away from the amorphous material layer 131 and is electrically connected to the second doped layer 132. The second electrode 160 is located on the second transparent conductive layer 170. Materials and advantages of the second transparent conductive layer 170 can be understood and implemented with reference to the first transparent conductive layer 150, and are not repeated herein.

In some embodiments of the present invention, with continued reference to FIG. 1, the back contact cell 100 further includes a passivation antireflection layer 180, and the passivation antireflection layer 180 is provided on the second surface m2 of the substrate 110. The passivation antireflection layer 180 may have a single layer structure or a multi-layer structure. In the passivation antireflection layer 180 with a multi-layer structure, each layer may be made of silicon oxide, silicon nitride, silicon oxynitride, or the like. The present invention has no limitations in this respect.

In some embodiments of the present invention, with continued reference to FIG. 1, the second zone m12 of the first surface m1 is provided with a pyramid-shaped structure. Certainly, the second surface m2 may be provided with a pyramid-shaped structure. Thus, a light utilization rate can be improved.

In some embodiments of the present invention, with continued reference to FIG. 2, along the arrangement direction of the first zones m11 and the second zones m12, a ratio of the size of the edge region mb to the size of the middle region mz is 0.2 to 1.

In some embodiments, taking FIG. 2 as an example, the size of the edge region mb in the arrangement direction of the first zones m11 and the second zones m12 is the size of the edge region mb in the second direction F2. The size of the edge region mb in the second direction F2 is a third size h3. The size of the middle region mz in the arrangement direction of the first zones m11 and the second zones m12 is the size of the middle region mz in the second direction F2. The size of the middle region mz in the second direction F2 is a fourth size h4. The ratio of the third size h3 to the fourth size h4 is 0.2 to 1. For example, the ratio of the third size h3 to the fourth size h4 may be 0.2, 0.3, 0.4, 0.5, 0.6, 0.7, 0.8, 0.9, or 1. Certainly, the ratio of the third size h3 to the fourth size h4 may also be any other value within the range from 0.2 to 1, and is not limited herein.

Thus, by controlling the ratio of the sizes of the edge region mb and the middle region mz, the ratio of a photoelectric conversion region can be increased on the premise of suppressing edge leakage and recombination, so as to increase the area utilization rate of the back contact cell 100. In addition, the region ratio can improve a carrier collection path, and lower the risk of an insufficient effective area or aggravated influences of edge defects, thereby improving the photoelectric conversion efficiency, parallel resistance and cell performance stability.

In some embodiments of the present invention, with continued reference to FIG. 2, along the arrangement direction of the first zones m11 and the second zones m12, the size of the edge region mb is 0.3mm to 20mm, and the size of the middle region mz is 65mm to 190mm.

In some embodiments, taking FIG. 2 as an example, the third size h3 may be 0.3mm, 1mm, 2mm, 5mm, 8mm, 10mm, 12mm, 17mm or 20mm, and the fourth size h4 may be 65mm, 70mm, 80mm, 90mm, 100mm, 120mm, 150mm, 170mm or 190mm. Certainly, the third size h3 may also be any other value within the range from 0.3mm to 20mm, and the fourth size h4 may also be any other value within the range from 65mm to 190mm, which is not limited herein

Therefore, by controlling the range of the size of the edge region mb along the arrangement direction of the first zones m11 and the second zones m12 and the range of the size of the middle region mz along the arrangement direction of the first zones m11 and the second zones m12, the middle region mz can be larger, which is beneficial to increasing the integral generation quantity of light absorption and carriers, the size ratio of the edge region mb is also favorably controlled, and the risks of electric leakage, shunting and recombination aggravation at the edge region mb are lowered while the effective power generation area at the edge region mb is considered. Meanwhile, through size matching of the middle region mz and the edge region mb, the influence of the edge defects on the cell performance can be reduced while the carriers generated by the edge region mb are fully collected, thereby improving the performance of the back contact cell 100.

In some embodiments of the present invention, with continued reference to FIG. 1 to FIG. 3A, on the same edge region mb, along the arrangement direction of the first zones m11 and the second zones m12, the ratio q1 of the total size of the first passivation contact layers 120 to the total size of the second passivation contact layers 1301 on the second zones m12 satisfies: 1<q1≤2.

In some embodiments, q1 can be 1.1, 1.2, 1.3, 1.4, 1.5, 1.6, 1.7, 1.8, 1.9, or 2. Certainly, q1 can be any other value within the above range, and is not limited herein.

As such, based on the plural first zones m11 located on the edge region mb and the plural second zones m12 located on the edge region mb, by controlling the ratio of the total size of the first passivation contact layers 120 and the total size of the second passivation contact layers 1301 located on the second zones m12, it is beneficial to improving the overall passivation and carrier collection capabilities at the corresponding edge region mb more uniformly and efficiently.

In addition, under the conditions of "controlling the ratio of the sizes of the edge region mb and the middle region mz", "controlling the range of the size of the edge region mb in the arrangement direction of the first zones m11 and the second zones m12 and the range of the size of the middle region mz in the arrangement direction of the first zones m11 and the second zones m12" and "controlling the ratio of the total size of the first passivation contact layers 120 to the total size of the second passivation contact layers 1301 located on the second zones m12", besides the above-mentioned advantages, cooperative control can be realized in two aspects of region distribution and functional layer ratios, the effective photoelectric conversion area is increased, and meanwhile, the edge field effect passivation or carrier extraction capability is enhanced, and the area utilization ratio, edge protection and carrier collection are considered, so that the cell efficiency, stability and yield are synchronously improved. Under the control of the above ratio and size, manufacturing is also facilitated.

In some embodiments of the present invention, with continued reference to FIG. 1 to FIG. 3A, on the same edge region mb, along the arrangement direction of the first zones m11 and the second zones m12, the ratio q2 of the size of the first passivation contact layer 120 to the size of the second passivation contact layer 1301 on the second zone m12 satisfies: 1≤q2≤2. That is, the ratio of the first size h1 to the second size h2 is 1 to 2.

In some embodiments, q2 can be 1, 1.2, 1.4, 1.5, 1.7, 1.9, or 2. Certainly, q2 can be any other value within the above range, and is not limited herein.

In this way, based on the plural first zones m11 located on the edge region mb and the plural second zones m12 located on the edge region mb, by controlling the ratio of the size of the first passivation contact layer 120 and the size of the second passivation contact layer 1301 located on the second zone m12, more fine and uniform control over the local performance of the edge region mb can be realized at a unit structure level. Therefore, the improvement of the cell performance and yield is facilitated.

In some embodiments of the present invention, with continued reference to FIG. 1 to FIG. 3A, on the edge region mb, along the arrangement direction of the first zones m11 and the second zones m12, the size of the first passivation contact layer 120 is 200µm to 1000µm, and the size of the second passivation contact layer 1301 on the second zone m12 is 100µm to 500µm.

In some embodiments, with combined reference to FIG. 3A, the first size h1 can be 200µm, 300µm, 400µm, 500µm, 700µm, 800µm, 900µm, or 1000µm, and the second size h2 can be 100µm, 150µm, 200µm, 300µm, 400µm, 450µm, or 500µm. Certainly, the first size h1 may be any other value within the range from 200µm to 1000µm, and the second size h2 may be any other value within the range from 100µm to 500µm, which is not limited herein.

In this way, by controlling the size range of the single first passivation contact layer 120 and the size range of the single second passivation contact layer 1301 located on the second zone m12, more fine control can be realized on a unit level structure. Therefore, the improvement of the cell performance and yield is facilitated.

In addition, under the conditions of "controlling the ratio of the size of the first passivation contact layer 120 to the size of the second passivation contact layer 1301 located on the second zone m12" and "controlling the size range of the single first passivation contact layer 120 and the size range of the single second passivation contact layer 1301 located on the second zone m12", besides the above advantages, it is beneficial to enhancing the tolerance of the corresponding edge region mb to process deviations, improving a process window, and facilitating manufacturing.

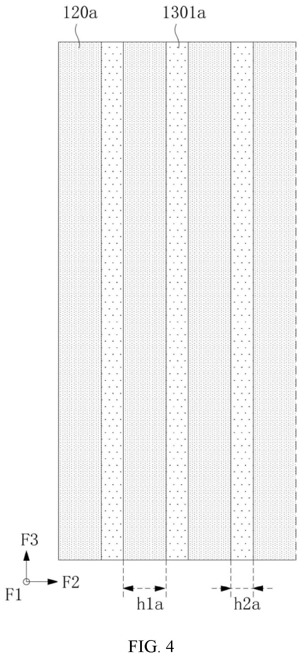

In some embodiments of the present invention, referring to FIG. 4, which is a schematic diagram of the first passivation contact layer 120a and the second passivation contact layer 1301a on the second zone m12 on the edge region mb in some other embodiments of the present invention, on at least one edge region mb, along the arrangement direction of the first zones m11 and the second zones m12, the size of the first passivation contact layer 120a is larger than the size of the second passivation contact layer 1301a on the second zone m12. That is, the first size h1a is greater than the second size h2a.

Thus, since the first size h1a is greater than the second size h2a, it is not only beneficial to causing the sum of the first sizes h1a to be greater than the sum of the second sizes h2a on the corresponding edge region mb, and also causing the first passivation contact layer 120a to have a larger manufacturing process window.

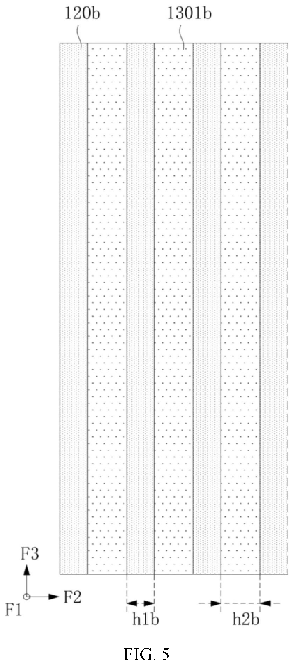

In some embodiments of the present invention, referring to FIG. 5, which is a schematic diagram of the first passivation contact layer 120b and the second passivation contact layer 1301b on the second zone m12 on the edge region mb. In still other embodiments of the present invention, on at least one edge region mb, along the arrangement direction of the first zones m11 and the second zones m12, the size of the first passivation contact layer 120b is less than the size of the second passivation contact layer 1301b on the second zone m12. That is, the first size h1b is smaller than the second size h2b.

As such, since the first size h1b is less than the second size h2b, it is not only beneficial to reducing parasitic absorption of the first doped layer 122 at the first zone m11 on the corresponding edge region mb, but also beneficial to providing a larger acting space for the second passivation contact layer 1301b on the second zone m12 on the corresponding edge region mb.

Certainly, in some other embodiments of the present invention, with continued reference to FIG. 3A, on at least one edge region mb, along the arrangement direction of the first zones m11 and the second zones m12, the size of the first passivation contact layer 120 is equal to the size of the second passivation contact layer 1301 located on the second zone m12. That is, the first size h1 is equal to the second size h2. The present invention has no limitations in this respect.

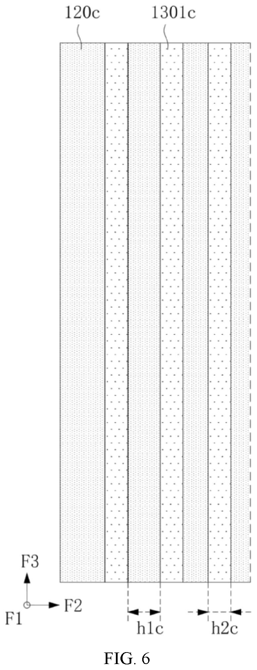

In some embodiments of the present invention, with continued reference to FIG. 2 in conjunction with FIG. 6, which is a schematic diagram of the first passivation contact layer 120c and the second passivation contact layer 1301c on the second zone m12 on the edge region mb. In yet other embodiments of the present invention, the edge region mb has a first side connected to the middle region mz and a second side opposite to the first side. On the same edge region mb, from the first side of the edge region mb to the second side of the edge region mb, along the arrangement direction of the first zones m11 and the second zones m12, the sizes of the first passivation contact layers 120c gradually increase. That is, on the same edge region mb, the first sizes h1c gradually increase from the first side of the edge region mb to the second side of the edge region mb.

With combined reference to FIG. 6, the gradually increasing means that the first sizes h1c are substantially increased from the first side of the edge region mb to the second side of the edge region mb on the same edge region mb. The first sizes h1c may be constant first and then increased, or may be increased first, then constant and then increased, or may be increased all the time, which is not limited herein. That is, the gradually increasing is a substantial trend.

As such, the field effect passivation strength at the corresponding edge region mb can be gradually enhanced, the carrier recombination, electric leakage and shunting phenomena caused by edge defects can be better inhibited, and the parallel resistance and the electrical performance stability of the edge region mb can be improved. Meanwhile, the design can also lower the risk of interface stress concentration or difficulty in process control caused by the size change of the first passivation contact layer 120c, realize more stable transition of the passivation capability, and further improve the overall photoelectric conversion efficiency, yield and reliability of the cell.

It should be noted that, during actual measurement, due to factors such as the measurement accuracy of an instrument, the local difference of sampling points, test noise or individual abnormal sampling points, temporary fluctuation or local errors in the sizes of a small number of test points are allowed. As long as an overall change is an increase and overall distribution conforms to an increasing rule, the definition that the sizes gradually increase is satisfied.

In some embodiments of the present invention, with continued reference to FIG. 2 and FIG. 6, on the same edge region mb, from the first side of the edge region mb to the second side of the edge region mb, along the arrangement direction of the first zones m11 and the second zones m12, the size of the previous first passivation contact layer 120c is less than the size of the subsequent first passivation contact layer 120c. That is, on the same edge region mb, from the first side of the edge region mb to the second side of the edge region mb, the previous first size h1c is less than the subsequent first size hlc. On the same edge region mb, the sizes of the first passivation contact layers 120c in the second direction F2 are increased sequentially from the first side of the edge region mb to the second side of the edge region mb.

Therefore, the field effect passivation strength and the interface protection capability of the edge region mb can be gradually enhanced, the carrier recombination, electric leakage and shunting phenomena at the edge can be more effectively inhibited, and the parallel resistance and the electrical performance stability of the edge region mb can be improved. Meanwhile, the gradual increase and continuous transition manner can further reduce the problems of process control difficulty and interface stress caused by a sudden size change, thus further improving the photoelectric conversion efficiency, performance uniformity and mass product yield.

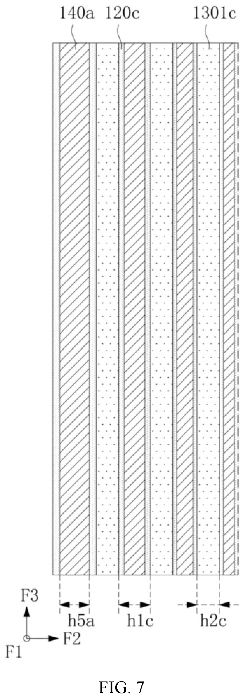

In some embodiments of the present invention, with continued reference to FIG. 2 and FIG. 6 in conjunction with FIG. 7, which is a schematic diagram of the first passivation contact layer 120c, the second passivation contact layer 1301c on the second zone m12 and a first electrode 140a on the edge region mb. In yet other embodiments of the present invention, on the same edge region mb, from the first side of the edge region mb to the second side of the edge region mb, along the arrangement direction of the first zones m11 and the second zones m12, the sizes of the first electrodes 140a gradually increase.

The size of the first electrode 140a along the second direction F2 is a fifth size h5a. That is, on the same edge region mb, the fifth sizes h5a gradually increase from the first side of the edge region mb to the second side of the edge region mb. The size of the first electrode 140a along the second direction F2 can be considered as the width of the first electrode 140a.

The gradually increasing can be understood and implemented with reference to the foregoing illustration, and is not repeated herein.

Therefore, a transverse conductive capability can be gradually enhanced, the edge carrier recombination, shunting and electric leakage can be more effectively inhibited, and the parallel resistance and electrical performance stability of the cell are improved. Meanwhile, by controlling the size of the first electrode 140a, the current collection uniformity of the edge region mb can be improved, local series resistance can be reduced, and the risk of stress concentration and the process control difficulty caused by the sudden size change of the electrode can be lowered. In addition, since the change trend of the size of the first electrode 140a along the second direction F2 is the same as the change trend of the size of the first passivation contact layer 120c along the second direction F2, the change trend of the size of the first passivation contact layer 120c along the second direction F2 can be utilized to enlarge a process manufacturing window of the first electrode 140a.

It should be understood that in the case where the back contact cell 100 includes the second transparent conductive layer 170, it is also advantageous to increasing the size of the second transparent conductive layer 170 on the edge region mb on the first zone m11, thereby contributing to further reducing the loss of direct transmission of charges from the passivation contact structure to the electrode.

In some embodiments of the present invention, with continued reference to FIG. 2, FIG. 6 and FIG. 7, on the same edge region mb, from the first side of the edge region mb to the second side of the edge region mb, along the arrangement direction of the first zones m11 and the second zones m12, the size of the previous first electrode 140a on the first zone m11 is less than the size of the subsequent first electrode 140a on the first zone m11. That is, on the same edge region mb, from the first side of the edge region mb to the second side of the edge region mb, the previous fifth size h5a is less than the subsequent fifth size h5a. On the same edge region mb, the sizes of the first electrodes 140a in the second direction F2 are increased sequentially from the first side of the edge region mb to the second side of the edge region mb.

Thus, by gradually increasing the conductive areas of the first electrodes 140a and the field effect passivation assisting effect, the carrier recombination, shunting and electric leakage of the edge region mb can be further suppressed, and the parallel resistance and electrical performance stability of the cell can be improved. Meanwhile, the sequential increase of the sizes of the first electrodes 140a in the second direction F2 can further improve the efficiency of transverse transport and collection of a current in the edge region mb, reduce the local series resistance, and improve current output uniformity.

In some embodiments of the present invention, with continued reference to FIG. 2, FIG. 6 and FIG. 7, on the same edge region mb, along the arrangement direction of the first zones m11 and the second zones m12, the size of the first electrode 140a ranges from 30µm to 70µm.

In some embodiments, the fifth size h5a may be 30µm, 40µm, 50µm, 60µm, 65 µm, or 70µm. Certainly, the fifth size h5a may also be any other value within the range from 30µm to 70µm, and is not limited herein.

In this way, by controlling the range of the size of the first electrode 140a along the second direction F2, the light-shielding area of the first electrode 140a can be considered on the premise of achieving a good transverse conductive capability and current collecting effect.

In addition, by controlling the change trend of the size of the first electrode 140a along the second direction F2 and the range of the size of the first electrode 140a along the second direction F2, the aforementioned advantages can be achieved.

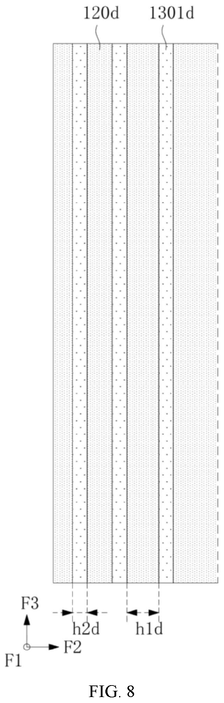

In some embodiments of the present invention, with continued reference to FIG. 2 in conjunction with FIG. 8, which is a schematic diagram of the first passivation contact layer 120d and the second passivation contact layer 1301d on the second zone m12 on the edge region mb. In some other embodiments of the present invention, on the same edge region mb, from the first side of the edge region mb to the second side of the edge region mb, along the arrangement direction of the first zones m11 and the second zones m12, the sizes of the first passivation contact layers 120d gradually decrease. That is, on the same edge region mb, the first sizes h1d gradually decrease from the first side of the edge region mb to the second side of the edge region mb.

With combined reference to FIG. 8, the gradually decreasing means that the first sizes h1d are substantially decreased from the first side of the edge region mb to the second side of the edge region mb on the same edge region mb. The first sizes h1d may be constant first and then decreased, or may be decreased first, then constant and then decreased, or may be decreased all the time, which is not limited herein. That is, the gradually decreasing is a substantial trend.

Thus, under the structural layout in which the whole edge region mb occupies a relatively larger area, the local ratio of a field passivation region can be reduced, and a larger acting space is correspondingly provided for a carrier separation and collection region, so that the carrier extraction, separation and transport capability at the edge region mb can be improved while the passivation effect at the edge region mb is improved, thereby improving the efficiency of collection of photogenerated carriers and the effective area utilization rate at the edge region mb.

It should be noted that, during actual measurement, due to factors such as the measurement accuracy of an instrument, the local difference of sampling points, test noise or individual abnormal sampling points, temporary fluctuation or local errors in the sizes of a small number of test points are allowed. As long as an overall change is a decrease and overall distribution conforms to a decreasing rule, the definition that the sizes gradually decrease is satisfied.

In some embodiments of the present invention, with continued reference to FIG. 2 and FIG. 8, on the same edge region mb, from the first side of the edge region mb to the second side of the edge region mb, along the arrangement direction of the first zones m11 and the second zones m12, the size of the previous first passivation contact layer 120d is greater than the size of the subsequent first passivation contact layer 120d. That is, on the same edge region mb, from the first side of the edge region mb to the second side of the edge region mb, the previous first size h1d is greater than the subsequent first size h1d. On the same edge region mb, the sizes of the first passivation contact layers 120d in the second direction F2 are decreased sequentially from the first side of the edge region mb to the second side of the edge region mb.

Therefore, under the structural layout in which the whole edge region mb occupies a relatively large area, the ratio of the field passivation region can be gradually reduced, so that the size ratio of the carrier separation and collection region can be enlarged, and on the premise that the edge region mb has enough field passivation effect and the edge recombination and electric leakage are inhibited, the carrier extraction, separation and transport capability of the edge region mb can be improved, and the efficiency of collection of photogenerated carriers and the effective area utilization rate at the edge region mb are improved. Moreover, the gradually decreased size arrangement can realize stable transition and reasonable distribution of the field passivation effect and the carrier collection effect, lower the risks of process control difficulty and performance fluctuation caused by the local size sudden change, and further improve the current output uniformity and the photoelectric conversion efficiency of the cell.

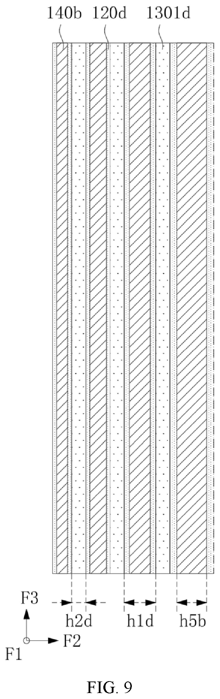

In some embodiments of the present invention, with continued reference to FIG. 2 and FIG. 8 in conjunction with FIG. 9, which is a schematic diagram of the first passivation contact layer 120d, the second passivation contact layer 1301d on the second zone m12 and the first electrode 140b on the edge region mb. In some other embodiments of the present invention, on the same edge region mb, from the first side of the edge region mb to the second side of the edge region mb, along the arrangement direction of the first zones m11 and the second zones m12, the sizes of the first electrodes 140b have a decreasing trend. That is, on the same edge region mb, the fifth sizes h5b gradually decrease from the first side of the edge region mb to the second side of the edge region mb.

The gradually decreasing can be understood and implemented with reference to the foregoing illustration, and is not repeated herein.

Thus, since the change trend of the size of the first electrode 140b along the second direction F2 is the same as the change trend of the size of the first passivation contact layer 120d along the second direction F2, the first electrode 140b and the first passivation contact layer 120d can realize synchronous matching of sizes, functions and acting regions on the edge region mb, thereby facilitating the cooperation of field passivation, electrode conduction and carrier collection, and further improving the photoelectric conversion efficiency, current uniformity and structural stability of the cell.

In some embodiments of the present invention, with continued reference to FIG. 2, FIG. 8 and FIG. 9, on the same edge region mb, from the first side of the edge region mb to the second side of the edge region mb, along the arrangement direction of the first zones m11 and the second zones m12, the size of the previous first electrode 140b on the first zone m11 is greater than the size of the subsequent first electrode 140b on the first zone m11. That is, on the same edge region mb, from the first side of the edge region mb to the second side of the edge region mb, the previous fifth size h5b is greater than the subsequent fifth size h5b. On the same edge region mb, the sizes of the first electrodes 140b in the second direction F2 are decreased sequentially from the first side of the edge region mb to the second side of the edge region mb.

Therefore, the gradual decrease arrangement can realize the stable transition and reasonable distribution of the field passivation function and the carrier collection function, lower the risks of poor contact, stress concentration, high process control difficulty, or the like, caused by the sudden size change, cause the current output of the edge region mb to be more uniform, and further improve the photoelectric conversion efficiency, electrical performance stability and mass production yield of the cell.

It should be noted that, under the condition that "on the same edge region mb, from the first side of the edge region mb to the second side of the edge region mb, along the arrangement direction of the first zones m11 and the second zones m12, the size of the previous first electrode 140b on the first zone m11 is greater than the size of the subsequent first electrode 140b on the first zone m11", the size of the first electrode 140b along the second direction F2 (i.e., the fifth size h5b) may also be 30µm to 70µm as illustrated in the foregoing embodiments. For related implementations and advantages, reference may be made to the contents illustrated in the foregoing embodiments, and details are not repeated herein.

In some embodiments of the present invention, with continued reference to FIG. 2 and FIG. 3A, on the same edge region mb, along the arrangement direction of the first zones m11 and the second zones m12, the sizes of the first passivation contact layers 120 are the same. That is, the corresponding first sizes h1 on the same edge region mb are the same. Certainly, in the case illustrated in FIG. 4 and FIG. 5, the first passivation contact layers 120a have the same size (i.e., the same first size h1a), and the first passivation contact layers 120b have the same size (i.e., the same first size hlb).

In this way, the first passivation contact layers 120 on the edge region mb can be distributed more uniformly, so that the risk of insufficient passivation can be lowered. Meanwhile, the structure with a uniform size is more beneficial to process control.

In some embodiments of the present invention, with continued reference to FIG. 2, FIG. 6 and FIG. 7, on the same edge region mb, along the arrangement direction of the first zones m11 and the second zones m12, the first passivation contact layers 120c have multiple sizes, and the sizes of adjacent two first passivation contact layers 120c are different. That is, the first sizes h1c corresponding to two first passivation contact layers 120c adjacent along the second direction F2 are different. In FIG. 8 and FIG. 9, the first sizes h1d corresponding to two first passivation contact layers 120d adjacent along the second direction F2 are also different.

Therefore, the size of the field passivation region can be finely and differentially adapted according to the defect distribution, the recombination degree and the carrier transport requirements of different positions on the edge region mb. Meanwhile, the diversified sizes also improve the flexibility and adaptability of structural design.

In some implementations, on the same edge region mb, along the arrangement direction of the first zones m11 and the second zones m12, the first electrodes 140 have multiple sizes, and the sizes of adjacent two first electrodes 140 are different. Thus, the change trend of the size of the first electrode 140 is the same as the change trend of the size of the first passivation contact layer 120. Thus, it is beneficial to improving the structural reliability of the cell by using the change trend of the size of the first electrode 140.

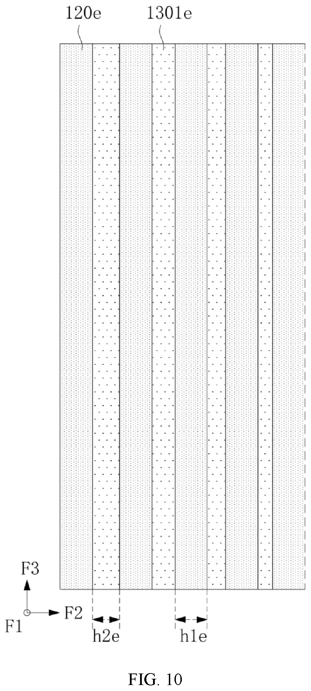

In some embodiments of the present invention, with continued reference to FIG. 2 in conjunction with FIG. 10, which is a schematic diagram of the first passivation contact layer 120e and the second passivation contact layer 1301e on the second zone m12 on the edge region mb. In some other embodiments of the present invention, on the same edge region mb, from the first side of the edge region mb to the second side of the edge region mb, along the arrangement direction of the first zones m11 and the second zones m12, the sizes of the second passivation contact layers 1301e on the second zones m12 gradually increase. That is, on the same edge region mb, the second sizes h2e gradually increase from the first side of the edge region mb to the second side of the edge region mb.

For the understanding of the increasing trend and the implementation of the measuring process, reference can be made to the situation illustrated in the foregoing description, and details are not repeated herein.

Therefore, on the one hand, the carrier separation, extraction and transport capability of the edge region mb can be gradually improved, the photogenerated carriers of the edge region mb can be more sufficiently collected, and the photoelectric conversion efficiency and the current uniformity are improved; on the other hand, from the force application and stress distribution perspective, the sizes of the second passivation contact layers 1301e located on the second zones m12 gradually increase, so that the stress areas and the interface bonding regions of the layers can be increased stably from inside to outside, which is beneficial to dispersing and releasing the stress concentration of the edge region mb, reducing the shear stress and local stress sudden change between layer interfaces, lowering the risk of layer warping, cracking, falling or poor contact in manufacturing and use processes of the cell, and improving the mechanical stability and the structural reliability of the edge region mb.

Furthermore, it can be understood that, under the structural layout in which the whole edge region mb occupies a relatively larger area, the size of the second passivation contact layer 1301e located on the second zone m12 under the aforementioned increasing trend can be adjusted more flexibly.

In some embodiments of the present invention, with continued reference to FIG. 2 and FIG. 10, on the same edge region mb, from the first side of the edge region mb to the second side of the edge region mb, along the arrangement direction of the first zones m11 and the second zones m12, the size of the previous second passivation contact layer 1301e on the second zone m12 is less than the size of the subsequent second passivation contact layer 1301e on the second zone m12. That is, on the same edge region mb, from the first side of the edge region mb to the second side of the edge region mb, the previous second size h2e is less than the subsequent second size h2e. On the same edge region mb, the sizes of the second passivation contact layers 1301e on the second zones m12 in the second direction F2 are increased sequentially from the first side of the edge region mb to the second side of the edge region mb.

Therefore, the photogenerated carriers in the edge region mb can be extracted and transported more fully, and the current collection efficiency and the photoelectric conversion utilization rate of the edge region mb are improved.

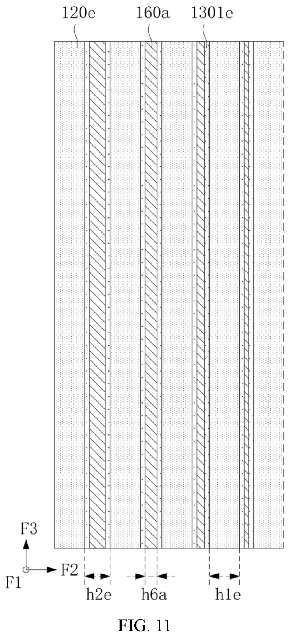

In some embodiments of the present invention, with continued reference to FIG. 2 and FIG. 10 in conjunction with FIG. 11, which is a schematic diagram of the first passivation contact layer 120e, the second passivation contact layer 1301e on the second zone m12 and a second electrode 160a on the edge region mb. In some other embodiments of the present invention, on the same edge region mb, from the first side of the edge region mb to the second side of the edge region mb, along the arrangement direction of the first zones m11 and the second zones m12, the sizes of the second electrodes 160a gradually increase.

The size of the second electrode 160a along the second direction F2 is a sixth size h6a. That is, on the same edge region mb, the sixth sizes h6a gradually increase from the first side of the edge region mb to the second side of the edge region mb. The size of the second electrode 160a along the second direction F2 can be considered as the width of the second electrode 160a.

The gradually increasing can be understood and implemented with reference to the foregoing illustration, and is not repeated herein.

Thus, the carrier collection and transverse conductive capabilities can be enhanced gradually, and the risk of stress concentration at the edge region mb can be lowered. In addition, since the change trend of the size of the second electrode 160a along the second direction F2 is the same as the change trend of the size of the second passivation contact layer 1301e on the second zone m12 along the second direction F2, the change trend of the size of the second passivation contact layer 1301e on the second zone m12 along the second direction F2 can be utilized to enlarge a process manufacturing window of the second electrode 160a.

It should be understood that in the case where the back contact cell 100 includes the second transparent conductive layer 170, it is also advantageous to increasing the size of the second transparent conductive layer 170 on the edge region mb on the second zone m12, thereby contributing to further reducing the loss of direct transmission of charges from the passivation contact structure to the electrode.

In some embodiments of the present invention, with continued reference to FIG. 2, FIG. 10 and FIG. 11, on the same edge region mb, from the first side of the edge region mb to the second side of the edge region mb, along the arrangement direction of the first zones m11 and the second zones m12, the size of the previous second electrode 160a on the second zone m12 is less than the size of the subsequent second electrode 160a on the second zone m12. That is, on the same edge region mb, from the first side of the edge region mb to the second side of the edge region mb, the previous sixth size h6a is less than the subsequent sixth size h6a. On the same edge region mb, the sizes of the second electrodes 160a in the second direction F2 are increased sequentially from the first side of the edge region mb to the second side of the edge region mb.

Therefore, the carrier collection and transverse conductive capabilities can be improved gradually, the photogenerated carriers of the edge region mb can be more smoothly guided out, the series resistance is reduced, and the current output uniformity and the photoelectric conversion efficiency are improved. The contact area of the second electrode 160a can be increased gradually, thereby lowering the risk of stress concentration at the edge region mb, and improving the mechanical stability and the long-term reliability of the structure.

In some embodiments of the present invention, with continued reference to FIG. 2, FIG. 10 and FIG. 11, on the same edge region mb, along the arrangement direction of the first zones m11 and the second zones m12, the size of the second electrode 160a ranges from 30µm to 70µm.

In some embodiments, the sixth size h6a may be 30µm, 40µm, 50µm, 60µm, 65 µm, or 70µm. Certainly, the sixth size h6a may also be any other value within the range from 30µm to 70µm, and is not limited herein.

In this way, by controlling the range of the size of the second electrode 160a along the second direction F2, the light-shielding area of the second electrode 160a can be balanced on the premise of achieving a good transverse conductive capability and current collecting effect.

In addition, by controlling the change trend of the size of the second electrode 160a along the second direction F2 and the range of the size of the second electrode 160a along the second direction F2, the aforementioned advantages can be achieved.

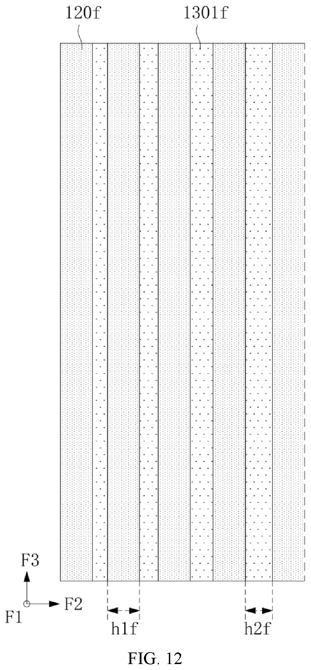

In some embodiments of the present invention, with continued reference to FIG. 2 in conjunction with FIG. 12, which is a schematic diagram of the first passivation contact layer 120f and the second passivation contact layer 1301f on the second zone m12 on the edge region mb. In some other embodiments of the present invention, on the same edge region mb, from the first side of the edge region mb to the second side of the edge region mb, along the arrangement direction of the first zones m11 and the second zones m12, the sizes of the second passivation contact layers 1301f on the second zones m12 gradually decrease. That is, the second size h2f has a decreasing trend.

For the understanding and related implementations of the decreasing trend, reference can be made to the decreasing trend illustrated in the foregoing embodiment, and details are not repeated herein.

Therefore, on the one hand, the occupied area of the carrier separation and collection region can be gradually reduced, and more spaces are correspondingly released for the field passivation region on the first zone m11, thereby improving the field effect passivation, electric leakage suppression and interface protection capabilities of the edge region mb, and improving the parallel resistance and electrical performance stability of the cell. On the other hand, the stress region of the layer can be stably transited from inside to outside, and the risk of stress concentration is lowered, thereby improving the mechanical stability and the long-term reliability of the cell.

In some embodiments of the present invention, with continued reference to FIG. 2 and FIG. 12, on the same edge region mb, from the first side of the edge region mb to the second side of the edge region mb, along the arrangement direction of the first zones m11 and the second zones m12, the size of the previous second passivation contact layer 1301f on the second zone m12 is greater than the size of the subsequent second passivation contact layer 1301f on the second zone m12. That is, on the same edge region mb, from the first side of the edge region mb to the second side of the edge region mb, the previous second size h2f is greater than the subsequent second size h2f. On the same edge region mb, the sizes of the second passivation contact layers 1301f on the second zones m12 in the second direction F2 are decreased sequentially from the first side of the edge region mb to the second side of the edge region mb.

Therefore, the occupied space of the carrier collection region can be reduced gradually along the edge extension direction, which is beneficial to increasing the ratio of the field passivation region, thereby gradually enhancing the field effect passivation, electric leakage suppression and composite protection capabilities of the edge region mb, and improving the parallel resistance and electrical performance stability of the cell. Meanwhile, since the sizes of the second passivation contact layers 1301F on the second zones m12 along the second direction F2 are sequentially reduced, a stress region of a layer interface can be gradually changed steadily, so that the stress distribution at the edge region mb is more uniform, and the mechanical stability and structural reliability of the cell are improved.

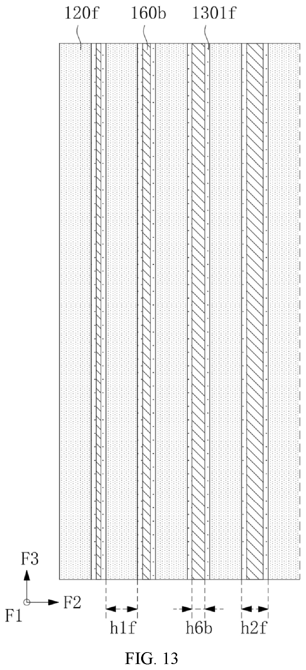

In some embodiments of the present invention, with continued reference to FIG. 2 and FIG. 12 in conjunction with FIG. 13, which is a schematic diagram of the first passivation contact layer 120f, the second passivation contact layer 1301f on the second zone m12 and the second electrode 160b on the edge region mb. In some other embodiments of the present invention, on the same edge region mb, from the first side of the edge region mb to the second side of the edge region mb, along the arrangement direction of the first zones m11 and the second zones m12, the sizes of the second electrodes 160b gradually decrease. That is, on the same edge region mb, the sixth sizes h6b gradually decrease from the first side of the edge region mb to the second side of the edge region mb.

The decreasing trend can be understood and implemented with reference to the foregoing illustration, and is not repeated herein.

Thus, since the change trend of the size of the second electrode 160b along the second direction F2 is the same as the change trend of the size of the second passivation contact layer 1301f on the second zone m12 along the second direction F2, the second electrode 160b and the second passivation contact layer 1301f on the second zone m12 can realize synchronous matching of sizes, functions and acting regions on the edge region mb, thereby facilitating a further improvement of the photoelectric conversion efficiency, current uniformity and structural stability of the cell.

In some embodiments of the present invention, with continued reference to FIG. 2, FIG. 12 and FIG. 13, on the same edge region mb, from the first side of the edge region mb to the second side of the edge region mb, along the arrangement direction of the first zones m11 and the second zones m12, the size of the previous second electrode 160b on the second zone m12 is greater than the size of the subsequent second electrode 160b on the second zone m12. That is, on the same edge region mb, from the first side of the edge region mb to the second side of the edge region mb, the previous sixth size h6b is greater than the subsequent sixth size h6b. On the same edge region mb, the sizes of the second electrodes 160b in the second direction F2 are decreased sequentially from the first side of the edge region mb to the second side of the edge region mb.

Therefore, the occupied area of the second electrode 160b in the edge region mb can be reduced gradually, more spaces are reserved for the field passivation region and a light transmission region correspondingly, and on the premise that a basic current can be led out, the field passivation effect, the electric leakage suppression capability and the light absorption utilization rate in the edge region mb are improved, and the parallel resistance and the photoelectric conversion efficiency of the cell are improved. Meanwhile, the stress distribution at the edge region mb can be more uniform, and the mechanical stability and structural reliability of the cell are improved.

It should be noted that, under the condition that "on the same edge region mb, from the first side of the edge region mb to the second side of the edge region mb, along the arrangement direction of the first zones m11 and the second zones m12, the size of the previous second electrode 160b on the second zone m12 is greater than the size of the subsequent second electrode 160b on the second zone m12", the size of the second electrode 160b along the second direction F2 (i.e., the sixth size h6b) may also be 30µm to 70µm as illustrated in the foregoing embodiments. For related implementations and advantages, reference may be made to the contents illustrated in the foregoing embodiments, and details are not repeated herein.

In some embodiments of the present invention, with continued reference to FIG. 2 and FIG. 3A, on the same edge region mb, along the arrangement direction of the first zones m11 and the second zones m12, the sizes of the second passivation contact layers 1301 on the second zones m12 are the same. That is, the second sizes h2 corresponding to the second passivation contact layers 1301 on the second zones m12 on the same edge region mb are the same. Certainly, in the case illustrated in FIG. 4 to FIG. 9, the sizes of the second passivation contact layers 1301a on the second zones m12 (i.e., the second sizes h2a) are the same, the sizes of the second passivation contact layers 1301b on the second zones m12 (i.e., the second sizes h2b) are the same, the sizes of the second passivation contact layers 1301c on the second zones m12 (i.e., the second sizes h2c) are the same, and the sizes of the second passivation contact layers 1301d on the second zones m12 (i.e., the second sizes h2d) are the same.

In this way, the second passivation contact layers 1301 on the second zones m12 on the edge region mb can be more uniformly distributed, thereby improving the current uniformity and photoelectric conversion stability of the cell. Meanwhile, the structure with a uniform size is more beneficial to process control.

Certainly, in some implementations, in combination with the situation illustrated in some of the foregoing embodiments, in the situation illustrated in FIG. 10 to FIG. 13, on the same edge region mb, the first passivation contact layers 120e have the same size (i.e., the same first size h1e), and the first passivation contact layers 120f have the same size (i.e., the same first size h1f). For related advantages, reference can be made to the above-mentioned illustrations, and details are not repeated herein.

In some embodiments of the present invention, with continued reference to FIG. 2, FIG. 10 and FIG. 11, on the same edge region mb, along the arrangement direction of the first zones m11 and the second zones m12, the second passivation contact layers 1301e on the second zones m12 have multiple sizes, and the sizes of adjacent two second passivation contact layers 1301e on the second zones m12 are different. That is, the second sizes h2e corresponding to two second passivation contact layers 1301e on the second zones m12 adjacent along the second direction F2 are different. In FIG. 12 and FIG. 13, the second sizes h2f corresponding to two second passivation contact layers 1301f on the second zones m12 adjacent along the second direction F2 are also different.

Therefore, the size of the second passivation contact layer 1301e on the second zone m12 can be finely and differentially adjusted according to the defect distribution, combination strength, light transmission requirements and carrier transport capabilities of different positions on the edge region mb, local electrical characteristics can be flexibly matched, carrier collection, passivation protection and local optimal distribution of light transmission areas are realized, and the overall electrical performance uniformity and photoelectric conversion efficiency at the edge region mb are improved.

In some implementations, on the same edge region mb, along the arrangement direction of the first zones m11 and the second zones m12, the second electrodes 160 have multiple sizes, and the sizes of adjacent two second electrodes 160 are different. Thus, the change trend of the size of the second electrode 160 is the same as the change trend of the size of the second passivation contact layer on the second zone m12. Thus, it is beneficial to improving the structural reliability of the cell by using the change trend of the size of the second electrode 160.

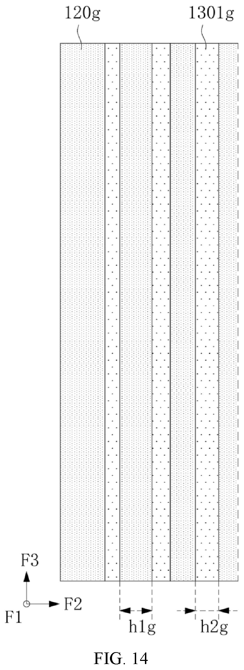

In some embodiments of the present invention, with continued reference to FIG. 2 in conjunction with FIG. 14, which is a schematic diagram of the first passivation contact layer 120g and the second passivation contact layer 1301g on the second zone m12 on the edge region mb. In some other embodiments of the present invention, on the same edge region mb, from the first side of the edge region mb to the second side of the edge region mb, along the arrangement direction of the first zones m11 and the second zones m12, the sizes of the first passivation contact layers 120g gradually increase, and the sizes of the second passivation contact layers 1301g on the second zones m12 gradually decrease. That is, on the same edge region mb, from the first side of the edge region mb to the second side of the edge region mb, the first sizes h1g gradually increase and the second size h2g gradually decrease.

The implementation that "on the same edge region mb, from the first side of the edge region mb to the second side of the edge region mb, along the arrangement direction of the first zones m11 and the second zones m12, the sizes of the first passivation contact layers 120g gradually increase" and related advantages may be understood with reference to the situation illustrated in some of the foregoing embodiments, and the implementation "on the same edge region mb, from the first side of the edge region mb to the second side of the edge region mb, along the arrangement direction of the first zones m11 and the second zones m12, the sizes of the second passivation contact layers 1301g on the second zones m12 gradually decrease" and related advantages may be understood with reference to the situation illustrated in some of the foregoing embodiments, which are not repeated herein.

As such, by controlling the sizes of both the first passivation contact layer 120g and the second passivation contact layer 1301g on the second zone m12 on the edge region mb, complementary allocation of the field passivation region and the carrier collection region can be realized, thereby further contributing to the improvement of the performance of the cell.

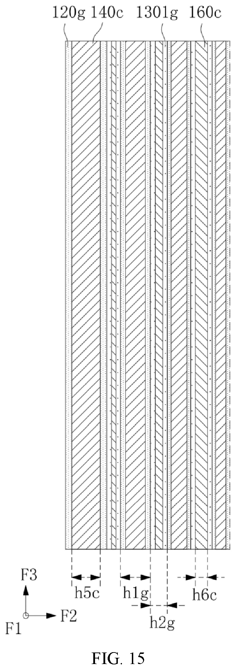

In some embodiments of the present invention, with continued reference to FIG. 2 and FIG. 14 in conjunction with FIG. 15, which is a schematic diagram of the first passivation contact layer 120g, the second passivation contact layer 1301g on the second zone m12, the first electrode 140c and the second electrode 160c on the edge region mb. In some other embodiments of the present invention, on the same edge region mb, from the first side of the edge region mb to the second side of the edge region mb, along the arrangement direction of the first zones m11 and the second zones m12, the sizes of the first electrodes 140c gradually increase, and the sizes of the second electrodes 160c gradually decrease. That is, on the same edge region mb, from the first side of the edge region mb to the second side of the edge region mb, the fifth sizes h5c gradually increase and the sixth size h6c gradually decrease.

The implementation that "on the same edge region mb, from the first side of the edge region mb to the second side of the edge region mb, along the arrangement direction of the first zones m11 and the second zones m12, the sizes of the first electrodes 140c gradually increase" and related advantages may be understood with reference to the situation illustrated in some of the foregoing embodiments, and the implementation "on the same edge region mb, from the first side of the edge region mb to the second side of the edge region mb, along the arrangement direction of the first zones m11 and the second zones m12, the sizes of the second electrodes 160c gradually decrease" and related advantages may be understood with reference to the situation illustrated in some of the foregoing embodiments, which are not repeated herein.

Therefore, on the one hand, the change trend of the size of the first passivation contact layer 120g and the change trend of the size of the second passivation contact layer 1301g on the second zone m12 can be matched, so that the conduction and contact stability of the field passivation region can be enhanced, the edge electric leakage and recombination can be better inhibited, the parallel resistance and edge reliability can be improved, a larger layout space can be reserved for the field passivation region and the first electrode 140c, and the edge protection effect is further improved. Meanwhile, since the first electrode 140c and the second electrode 160c have opposite size change trends, it is beneficial to dispersing stress concentration at the edge region mb, thereby improving the mechanical stability and long-term reliability of the cell structure.

It should be noted that, compared to the case where the first electrodes have the same size along the second direction F2 and the second electrodes have the same size along the second direction F2, the above control of the change trends of the sizes of the first electrode 140c and the second electrode 160c is also beneficial to reducing the materials used for the first electrode 140c and the second electrode 160c, thereby being beneficial to reducing the manufacturing cost. In addition, the arrangement of the electrodes with different widths is also beneficial to reducing the overall circuit resistance, thereby reducing the power loss and improving the output power. The electrodes with different widths can help to dissipate the heat generated in the cell, and lower the risk of occurrence of overheated regions, thereby improving stability and prolonging the service life.

In some other embodiments, the first passivation contact layers 120 on the two edge regions mb are symmetrically arranged about the middle region mz, and the second passivation contact layers 1301 on the second zones m12 on the two edge regions mb are symmetrically arranged about the middle region mz. Therefore, it is also conducive to further improving the stress condition of the whole cell.

In some other embodiments, on at least one edge region mb, the sizes of the first passivation contact layers 120 along the second direction F2 may be changed alternately, and the sizes of the second passivation contact layers 1301 on the second zones m12 along the second direction F2 may also be changed alternately. The alternating change means that the first passivation contact layers 120 have two sizes along the second direction F2, and two first passivation contact layers 120 adjacent along the second direction F2 have different sizes along the second direction F2; the second passivation contact layers 1301 on the second zones m12 have two sizes in the second direction F2, and two second passivation contact layers 1301 on the second zones m12 adjacent in the second direction F2 have different sizes in the second direction F2.

In this way, the first passivation contact layers 120 with two sizes and the second passivation contact layers 1301 on the second zones m12 with two sizes are alternately arranged, so that the field passivation regions and the carrier collection regions can form periodic and complementary distribution in the edge region mb, a dynamic balance between passivation protection and carrier collection is realized, and the electrical performance uniformity, parallel resistance and photoelectric conversion efficiency of the edge region mb are effectively improved.

In some embodiments of the present invention, with continued reference to FIG. 2 and FIG. 3A, the zone on at least one edge region mb farthest from the middle region mz is the first zone m11. In this case, it can be seen that the layer on the at least one edge region mb farthest from the middle region mz is the first passivation contact layer 120. Certainly, in the cases illustrated in FIG. 4 to FIG. 15, the layer on the edge region mb farthest from the middle region mz is illustrated to be the first passivation contact layer.

Therefore, the outermost part on the edge region mb can be directly protected, which further improves the effect of restraining edge electric leakage, surface recombination and bypass leakage currents, thereby further improving the performance of the cell.

Certainly, in some other embodiments, the zone on the at least one edge region mb farthest from the middle region mz may also be the second zone m12, which is not limited herein.

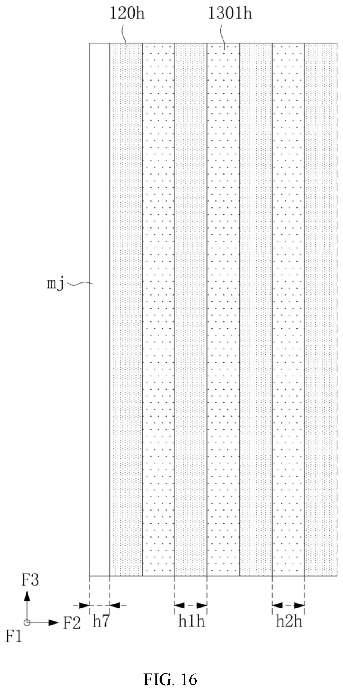

In some embodiments of the present invention, with continued reference to FIG. 2 in conjunction with FIG. 16, which is a schematic diagram of the first passivation contact layer 120h and the second passivation contact layer 1301h on the second zone m12 on the edge region mb. In some other embodiments of the present invention, at least one edge region mb includes a spacer zone mj. The zone on the at least one edge region mb farthest from the middle region mz is the spacer zone mj.

The spacer zone mj refers to an outermost region located on the edge region mb of the back contact cell 100 and farthest from the middle region mz. The spacer zone mj is not provided with a functional layer and is a blank isolation region.

Therefore, an electric leakage path on the edge surface can be directly cut off, the risks of surface recombination and bypass electric leakage caused by edge defects, impurities, scratches, or the like, are reduced, the process difficulty can be lowered, and the problems of residual edge layers, over-etching, falling, or the like, are reduced, which is beneficial to improving the yield and product consistency of mass production.

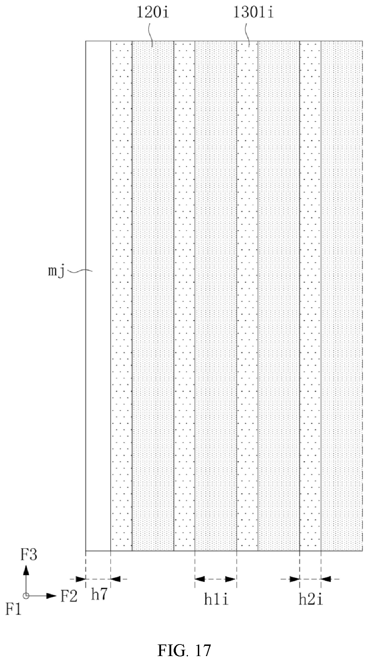

It should be noted that, taking FIG. 16 as an example, in the case where the spacer zone mj is provided, the size of the first passivation contact layer 120h in the second direction F2 (i.e., the first size hlh) and the size of the second passivation contact layer 1301h on the second zone m12 in the second direction F2 (i.e., the second size h2h) may be the same. Taking FIG. 17 as an example, FIG. 17 is a schematic diagram of the first passivation contact layer 120i and the second passivation contact layer 13011 on the second zone m12 on the edge region mb. In some other embodiments of the present invention, and in the case where the spacer zone mj is provided, the size of the first passivation contact layer 120i along the second direction F2 (i.e., the first size h1i) and the size of the second passivation contact layer 1301i on the second zone m12 along the second direction F2 (i.e., the second size h2i) may be different, which is not limited herein. It may be understood that other implementations of the size of the first passivation contact layer 120i along the second direction F2 and the size of the second passivation contact layer 1301i on the second zone m12 along the second direction F2 can also be implemented with reference to the situations illustrated in some of the foregoing embodiments, and are not repeated herein.

In some embodiments of the present invention, with continued reference to FIG. 16 and FIG. 17, the size of the spacer zone mj is 100µm to 300µm in the arrangement direction of the first zones m11 and the second zones m12. That is, the size of the spacer zone mj in the second direction F2 is a seventh size h7, and the seventh size h7 is 100µm to 300µm.

In some embodiments, the seventh size h7 may be 100µm, 110µm, 130µm, 150µm, 180µm, 200µm, 220µm, 280µm, or 300µm. Certainly, the seventh size h7 may also be any other value within the range from 100µm to 300µm, and is not limited herein.

Therefore, an effective power generation area and manufacturing convenience are considered while electrical isolation and edge stress reduction are realized.

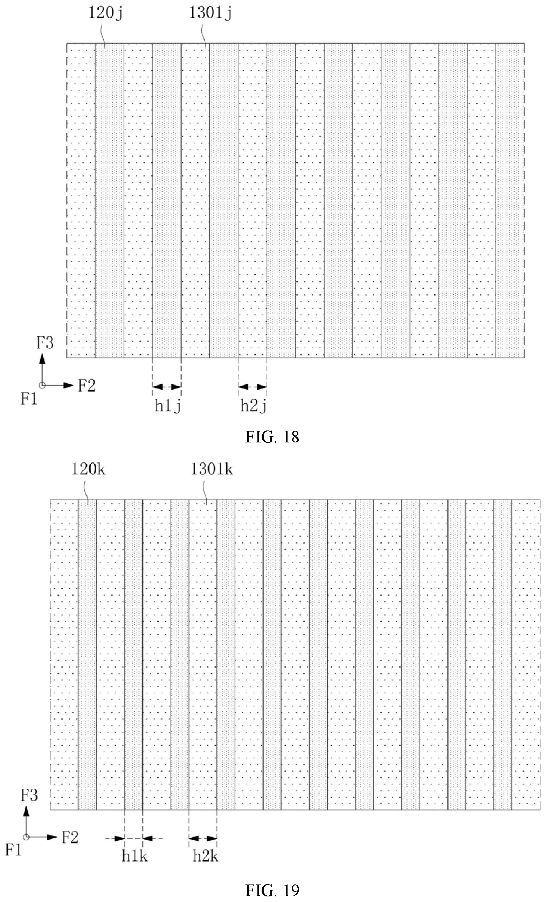

In some embodiments of the present invention, with continued reference to FIG. 2 in conjunction with FIG. 18, which is a schematic diagram of the first passivation contact layer 120j and the second passivation contact layer 1301j on the second zone m12 on the middle region mz. In some other embodiments of the present invention, on the middle region mz, along the arrangement direction of the first zones m11 and the second zones m12, the size of the first passivation contact layer 120j is equal to the size of the second passivation contact layer 1301j on the second zone m12. That is, the first size h1j is equal to the second size h2j.

Therefore, manufacturing is facilitated, and it is also beneficial to causing the whole cell to be stressed more uniformly.

In some embodiments of the present invention, with continued reference to FIG. 2 in conjunction with FIG. 19, which is a schematic diagram of the first passivation contact layer 120k and the second passivation contact layer 1301k on the second zone m12 on the middle region mz. In some other embodiments of the present invention, on the middle region mz, along the arrangement direction of the first zones m11 and the second zones m12, the total size of the first passivation contact layers 120k is less than the total size of the second passivation contact layers 1301k on the second zones m12.

Taking FIG. 19 as an example, the total size of the first passivation contact layers 120k in the arrangement direction of the first zones m11 and the second zones m12 on the middle region mz is the sum of the sizes of all the first passivation contact layers 120k in the second direction F2 on the middle region mz. The size of the first passivation contact layer 120k along the second direction F2 is a first size hlk. Similarly, the total size of the second passivation contact layers 1301k located on the second zones m12 in the arrangement direction of the first zones m11 and the second zones m12 on the middle region mz is the sum of the sizes of all the second passivation contact layers 1301k located on the second zones m12 in the second direction F2 on the middle region mz. The size of the second passivation contact layer 1301k on the second zone m12 along the second direction F2 is a second size h2k. That is, on the middle region mz, the total width of the first passivation contact layers 120k is less than the total width of the second passivation contact layers 1301k located on the second zones m12.

In some embodiments, continuously taking FIG. 19 as an example, with combined reference to FIG. 2, since both the first zone m11 and the second zone m12 extend lengthwise along the third direction F3, both the first zone m11 and the second zone m12 can be regarded as rectangular zones. The size of the first passivation contact layer 120k along the third direction F3 can be regarded as the length of the first passivation contact layer 120k, the size of the second passivation contact layer 1301k on the second zone m12 along the third direction F3 can be regarded as the length of the second passivation contact layer 1301k on the second zone m12, and the length of the first passivation contact layer 120k and the length of the second passivation contact layer 1301k on the second zone m12 are substantially the same. In the aforementioned case where "on the middle region mz, along the arrangement direction of the first zones m11 and the second zones m12, the total size of the first passivation contact layers 120k is less than the total size of the second passivation contact layers 1301k located on the second zones m12", the area ratio of the first passivation contact layer 120k is less than the area ratio of the second passivation contact layer 1301k located on the second zone m12 on the middle region mz.

The middle region mz is a main region of the cell where sufficient light is received and photogenerated carriers are concentrated, so that the defect density is low, the surface recombination and edge electric leakage are weak, and the requirements for carrier separation, collection and transport are higher. Therefore, by setting the total size of the first passivation contact layers 120k to be less than the total size of the second passivation contact layers 1301k on the second zones m12 on the middle region mz, the area of the carrier separation and collection region can be enlarged to the maximum extent on the premise of satisfying basic passivation protection, the carrier collection efficiency and the photoelectric conversion utilization rate of the middle region mz can be improved, occupation of the effective power generation region by the excessive large area of the field passivation region can be reduced, and the current output and conversion efficiency on the main region of the cell can be improved.

In addition, since a part of the first zones m11 and a part of the second zones m12 are located in the middle region mz, it is beneficial to enlarging an adjustment window for the size of the first passivation contact layer 120k in the arrangement direction of the first zones m11 and the second zones m12 and the size of the second passivation contact layer 1301k on the second zone m12 in the arrangement direction of the first zones m11 and the second zones m12, thereby being more beneficial to more flexibly controlling "the size of the first passivation contact layer 120k in the arrangement direction of the first zones m11 and the second zones m12" and "the size of the second passivation contact layer 1301k on the second zone m12 in the arrangement direction of the first zones m11 and the second zones m12", and then improving the performance of the back contact cell 100.

Thus, since on the middle region mz of the first surface m1 of the substrate 110, along the arrangement direction of the first zones m11 and the second zones m12, the total size of the first passivation contact layers 120k is less than the total size of the second passivation contact layers 1301k on the second zones m12, the total size of the first passivation contact layers 120k on the middle region mz along the arrangement direction of the first zones m11 and the second zones m12 and the total size of the second passivation contact layers 1301k on the second zones m12 along the arrangement direction of the first zones m11 and the second zones m12 are different. Under such structure, by adjusting the size of the first passivation contact layer 120k along the arrangement direction of the first zones m11 and the second zones m12 and the size of the second passivation contact layer 1301k on the second zone m12 along the arrangement direction of the first zones m11 and the second zones m12, and by utilizing the difference between the size of the first passivation contact layer 120k along the arrangement direction of the first zones m11 and the second zones m12 and the size of the second passivation contact layer 1301k on the second zone m12 along the arrangement direction of the first zones m11 and the second zones m12, light energy can be utilized to the maximum extent while the photoelectric conversion efficiency of the back contact cell 100 is considered, which is beneficial to improving the performance of the back contact cell 100.

It should be noted that, under the conditions that "on the middle region mz, along the arrangement direction of the first zones m11 and the second zones m12, the total size of the first passivation contact layers 120k is less than the total size of the second passivation contact layers 1301k on the second zones m12" and "on at least one edge region mb, along the arrangement direction of the first zones m11 and the second zones m12, the total size of the first passivation contact layers 120k is greater than the total size of the second passivation contact layers 1301k on the second zones m12", besides the advantages mentioned above, complementation between the middle region mz and the edge region mb is realized, and light energy is maximally utilized while the photoelectric conversion efficiency of the whole back contact cell 100 is considered, thereby further facilitating the improvement of the performance of the back contact cell 100.

In some embodiments of the present invention, with continued reference to FIG. 1, FIG. 2 and FIG. 19, on the middle region mz, along the arrangement direction of the first zones m11 and the second zones m12, the ratio q3 of the total size of the second passivation contact layers 1301k on the second zones m12 to the total size of the first passivation contact layers 120k satisfies: 1<q3≤2.

In some embodiments, q3 can be 1.1, 1.2, 1.3, 1.4, 1.5, 1.6, 1.7, 1.8, 1.9, or 2. Certainly, q3 can be any other value within the above range, and is not limited herein.

In this way, based on the plural first zones m11 located on the middle region mz and the plural second zones m12 located on the middle region mz, by controlling the ratio of the total size of the first passivation contact layers 120k and the total size of the second passivation contact layers 1301k located on the second zones m12, it is beneficial to improving the overall passivation and carrier collection capabilities at the corresponding middle region mz more uniformly and efficiently.

In addition, under the conditions of "controlling the ratio of the sizes of the edge region mb and the middle region mz", "controlling the range of the size of the middle region mz in the arrangement direction of the first zones m11 and the second zones m12 and the range of the size of the middle region mz in the arrangement direction of the first zones m11 and the second zones m12" and "controlling the ratio of the total size of the first passivation contact layers 120k to the total size of the second passivation contact layers 1301k located on the second zones m12", besides the above-mentioned advantages, cooperative control can be realized in two aspects of region distribution and functional layer ratios, the effective photoelectric conversion area is increased, and meanwhile, the edge field effect passivation or carrier extraction capability is enhanced, and the area utilization ratio, edge protection and carrier collection are considered, so that the cell efficiency, stability and yield are synchronously improved. Under the control of the above ratio and size, manufacturing is also facilitated.

In some embodiments of the present invention, with continued reference to FIG. 1, FIG. 2 and FIG. 19, on the middle region mz, along the arrangement direction of the first zones m11 and the second zones m12, the ratio q4 of the size of the second passivation contact layer 1301k on the second zone m12 to the size of the first passivation contact layer 120k satisfies: 1≤q4≤2. That is, the ratio of the second size h2k to the first size h1k is 1 to 2.

In some embodiments, q4 can be 1, 1.2, 1.4, 1.5, 1.7, 1.9, or 2. Certainly, q4 can be any other value within the above range, and is not limited herein.

In this way, based on the plurality of first zones m11 located on the middle region mz and the plurality of second zones m12 located on the middle region mz, by controlling the ratio of the size of the first passivation contact layer 120k and the size of the second passivation contact layer 1301k located on the second zone m12, more fine and uniform control over the local performance of the middle region mz can be realized at a unit structure level. Therefore, the improvement of the cell performance and yield is facilitated.

In some embodiments of the present invention, with continued reference to FIG. 1, FIG. 2 and FIG. 19, along the arrangement direction of the first zones m11 and the second zones m12, the size of the first passivation contact layer 120k is 100µm to 500µm, and the size of the second passivation contact layer 1301k on the second zone m12 is 200µm to 1000µm.

In some embodiments, with combined reference to FIG. 19, the first size h1k can be 100µm, 150µm, 200µm, 300µm, 400µm, 450µm, or 500µm, and the second size h2k can be 200µm, 300µm, 400µm, 500µm, 700µm, 800µm, 900µm, or 1000µm. Certainly, the first size h1k may be any other value within the range from 100µm to 500µm, and the second size h2k may be any other value within the range from 200µm to 1000µm, which is not limited herein.

In this way, by controlling the size range of the single first passivation contact layer 120k and the size range of the single second passivation contact layer 1301k located on the second zone m12, more fine control can be realized on a unit level structure. Therefore, the improvement of the cell performance and yield is facilitated.

In addition, under the conditions of "controlling the ratio of the size of the first passivation contact layer 120k to the size of the second passivation contact layer 1301k located on the second zone m12" and "controlling the size range of the single first passivation contact layer 120k and the size range of the single second passivation contact layer 1301k located on the second zone m12", besides the above advantages, it is beneficial to enhancing the tolerance to process deviations, improving a process window, and facilitating manufacturing.

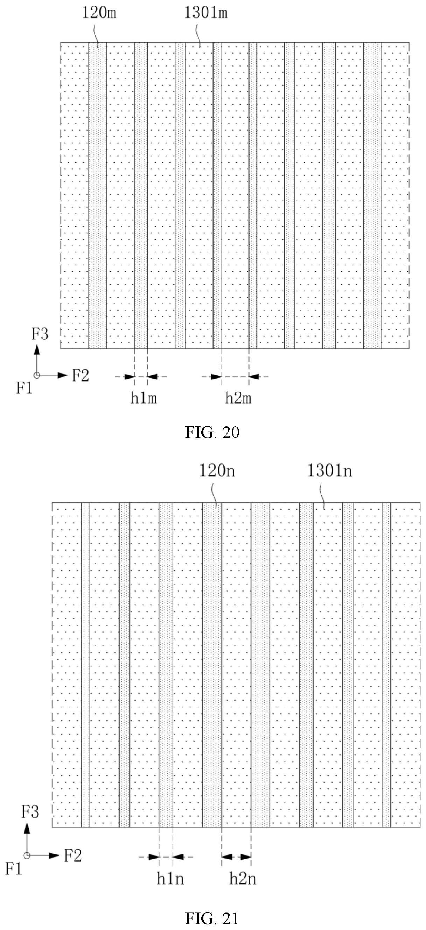

In some embodiments of the present invention, with continued reference to FIG. 2 in conjunction with FIG. 20, which is a schematic diagram of the first passivation contact layer 120m and the second passivation contact layer 1301m on the second zone m12 on the middle region mz. In still other embodiments of the present invention, on the middle region mz, from the center of the middle region mz to the edge of the middle region mz, along the arrangement direction of the first zones m11 and the second zones m12, the sizes of the first passivation contact layers 120m gradually increase. A direction from the center of the middle region mz to the edge of the middle region mz is parallel to the arrangement direction of the first zones m11 and the second zones m12. That is, the first sizes h1m gradually increase from the center of the middle region mz to the edge of the middle region mz.

With combined reference to FIG. 20, the gradually increasing means that the first sizes h1m are substantially increased from the center of the middle region mz to the edge of the middle region mz. The first sizes h1m may be constant first and then increased, or may be increased first, then constant and then increased, or may be increased all the time, which is not limited herein.

Since the center of the middle region mz receives sufficient light and has fewer defects and concentrated carriers, when the size of the first passivation contact layer 120m is smaller, the area of the carrier separation and collection region can be maximally improved, and the photoelectric conversion efficiency of the main region is improved. During transition from the center to the edge of the middle region mz, the defect density, surface recombination and stress level may be gradually increased, the size of the first passivation contact layer 120m is gradually increased, the passivation protection can be gradually enhanced, the recombination and electric leakage can be inhibited, and the electrical performance stability of the edge of the middle region mz can be improved. Thus, gradient and cooperative optimization of passivation protection and carrier collection in the middle region mz can be realized.

It should be noted that, during actual measurement, due to factors such as the measurement accuracy of an instrument, the local difference of sampling points, test noise or individual abnormal sampling points, temporary fluctuation or local errors in the sizes of a small number of test points are allowed. As long as an overall change is an increase and overall distribution conforms to an increasing rule, the definition that the sizes gradually increase is satisfied.

In some embodiments of the present invention, with continued reference to FIG. 2 and FIG. 20, on the middle region mz, from the center of the middle region mz to the edge of the middle region mz, along the arrangement direction of the first zones m11 and the second zones m12, the size of the previous first passivation contact layer 120m is less than the size of the subsequent first passivation contact layer 120m. That is, from the center of the middle region mz to the edge of the middle region mz, the previous first size h1m is less than the subsequent first size h1m. The sizes of the first passivation contact layers 120m in the second direction F2 are increased sequentially from the center of the middle region mz to the edge of the middle region mz.

Thus, the gradually increased structure can make overall structure transition more mild and process controllability better, and the protection capability is improved while power generation at the middle region mz is more efficient, thereby improving the performance of the cell.

In some embodiments of the present invention, with continued reference to FIG. 2 in conjunction with FIG. 21, which is a schematic diagram of the first passivation contact layer 120n and the second passivation contact layer 1301n on the second zone m12 on the middle region mz. In yet other embodiments of the present invention, on the middle region mz, from the center of the middle region mz to the edge of the middle region mz, along the arrangement direction of the first zones m11 and the second zones m12, the sizes of the first passivation contact layers 120n gradually decrease. A direction from the center of the middle region mz to the edge of the middle region mz is parallel to the arrangement direction of the first zones m11 and the second zones m12. That is, the first sizes h1n gradually decrease from the center of the middle region mz to the edge of the middle region mz.

With combined reference to FIG. 21, the gradually decreasing means that the first sizes h1n are substantially decreased from the center of the middle region mz to the edge of the middle region mz. The first sizes h1n may be constant first and then decreased, or may be decreased first, then constant and then decreased, or may be decreased all the time, which is not limited herein.

Thus, the carrier collection capability at the center of the middle region mz can be further improved, and meanwhile, more layout spaces of the second passivation contact layer 1301n on the second zone m12 are reserved for the edge of the middle region mz, so that the carrier separation and lead-out efficiency at the edge of the middle region mz is improved.

It should be noted that during actual measurement, the gradually decreasing can be understood by referring to the foregoing related description of the gradually increasing, and as long as an overall change is a decrease and overall distribution conforms to a decreasing rule, the definition that the sizes gradually decrease is satisfied, which is not repeated herein.

In some embodiments of the present invention, with continued reference to FIG. 2 and FIG. 21, on the middle region mz, from the center of the middle region mz to the edge of the middle region mz, along the arrangement direction of the first zones m11 and the second zones m12, the size of the previous first passivation contact layer 120n is greater than the size of the subsequent first passivation contact layer 120n. That is, on the same edge region mb, from the first side of the edge region mb to the second side of the edge region mb, the previous first size h1 is greater than the subsequent first size h1. On the same edge region mb, the sizes of the first passivation contact layers 120n in the second direction F2 are decreased sequentially from the first side of the edge region mb to the second side of the edge region mb.

Thus, the sizes of the first passivation contact layers 120n are gradually reduced from the center to the edge of the middle region mz, so that the layout space of the second passivation contact layer 1301n on the second zone m12 can be gradually increased, and the carrier separation and collection capability at the edge is further improved. Moreover, the gradually decreased size arrangement can realize stable transition and reasonable distribution of the field passivation effect and the carrier collection effect, lower the risks of process control difficulty and performance fluctuation caused by the local size sudden change, and further improve the current output uniformity and the photoelectric conversion efficiency of the cell.

In some embodiments of the present invention, with continued reference to FIG. 2 and FIG. 19, on the middle region mz, along the arrangement direction of the first zones m11 and the second zones m12, the sizes of the first passivation contact layers 120k are the same. That is, the first sizes h1k corresponding to the first passivation contact layers 120k on the middle region mz are the same.

In this way, the first passivation contact layers 120k on the edge region mb can be distributed more uniformly, so that the risk of insufficient passivation can be lowered. Meanwhile, the structure with a uniform size is more beneficial to process control.

In some embodiments of the present invention, with continued reference to FIG. 2 and FIG. 20, on the middle region mz, along the arrangement direction of the first zones m11 and the second zones m12, the first passivation contact layers 120m have multiple sizes, and the sizes of adjacent two first passivation contact layers 120m are different. That is, the first sizes h1m corresponding to two first passivation contact layers 120m adjacent along the second direction F2 are different. In FIG. 21, the first sizes h1m corresponding to two first passivation contact layers 120m adjacent along the second direction F2 are also different.

Therefore, the size of the field passivation region can be finely and differentially adapted according to the defect distribution, the recombination degree and the carrier transport requirements of different positions on the middle region mz. Meanwhile, the diversified sizes also improve the flexibility and adaptability of structural design.

In some embodiments, on the middle region mz, along the arrangement direction of the first zones m11 and the second zones m12, the first electrodes 140 have multiple sizes, and the sizes of adjacent two first electrodes 140 are different. Thus, the change trend of the size of the first electrode 140 is the same as the change trend of the size of the first passivation contact layer. Thus, it is beneficial to improving the structural reliability of the cell by using the change trend of the size of the first electrode 140.

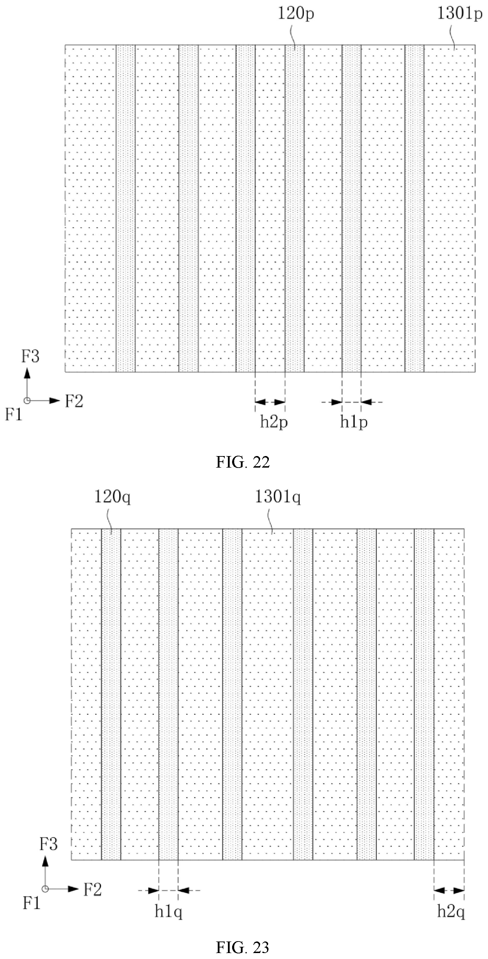

In some embodiments of the present invention, with continued reference to FIG. 2 in conjunction with FIG. 22, which is a schematic diagram of the first passivation contact layer 120p and the second passivation contact layer 1301p on the second zone m12 on the middle region mz. In some other embodiments of the present invention, on the middle region mz, from the center of the middle region mz to the edge of the middle region mz, along the arrangement direction of the first zones m11 and the second zones m12, the sizes of the second passivation contact layers 1301p on the second zones m12 gradually increase. A direction from the center of the middle region mz to the edge of the middle region mz is parallel to the arrangement direction of the first zones m11 and the second zones m12. That is, on the middle region mz, the second sizes h2p gradually increase from the center of the middle region mz to the edge of the middle region mz.

For the understanding of the gradually increasing and the implementation of the measuring process, reference can be made to the situation illustrated in the foregoing description, and details are not repeated herein.

Therefore, on the one hand, from the center of the middle region mz to the edge of the middle region mz, by gradually increasing the sizes of the second passivation contact layers 1301p located on the second zones m12, the carrier separation, collection and transverse conduction capacities can be gradually improved, the series resistance is reduced, the current output uniformity at the edge of the middle region mz is improved, and the overall electrical performance is improved; on the other hand, the sizes of the second passivation contact layers 1301p located on the second zones m12 may change more smoothly, so that local stress concentration may be relieved, the risk of warpage, cracking or falling of the layer may be reduced, and the interface bonding reliability may be improved.

In some embodiments of the present invention, with continued reference to FIG. 2 and FIG. 22, on the middle region mz, from the center of the middle region mz to the edge of the middle region mz, along the arrangement direction of the first zones m11 and the second zones m12, the size of the previous second passivation contact layer 1301p on the second zone m12 is less than the size of the subsequent second passivation contact layer 1301p on the second zone m12. That is, the previous second size h2p is less than the subsequent second size h2p from the center of the middle region mz to the edge of the middle region mz. The sizes of the second passivation contact layers 1301p on the second zones m12 in the second direction F2 are increased sequentially from the center of the middle region mz to the edge of the middle region mz.

Therefore, the photogenerated carriers in the edge region mb can be extracted and transported more fully, and the current collection efficiency and the photoelectric conversion utilization rate of the middle region mz are improved.

In some embodiments of the present invention, with continued reference to FIG. 2 in conjunction with FIG. 23, which is a schematic diagram of the first passivation contact layer 120q and the second passivation contact layer 1301q on the second zone m12 on the middle region mz. In some other embodiments of the present invention, on the middle region mz, from the center of the middle region mz to the edge of the middle region mz, along the arrangement direction of the first zones m11 and the second zones m12, the sizes of the second passivation contact layers 1301q on the second zones m12 gradually decrease. A direction from the center of the middle region mz to the edge of the middle region mz is parallel to the arrangement direction of the first zones m11 and the second zones m12.

For the understanding and related implementations of the gradually decreasing, reference can be made to the decreasing trend illustrated in the foregoing embodiment, and details are not repeated herein.

Therefore, on the one hand, the occupied area of the carrier separation and collection region can be gradually reduced, and more spaces are correspondingly released for the field passivation region on the first zone m11, thereby improving the field effect passivation, electric leakage suppression and interface protection capabilities at the edge of the middle region mz, and improving the parallel resistance and electrical performance stability of the cell. On the other hand, the stress region of the layer can be stably transited from inside to outside, and the risk of stress concentration is lowered, thereby improving the mechanical stability and the long-term reliability of the cell.

In some embodiments of the present invention, with continued reference to FIG. 2 and FIG. 23, on the middle region mz, from the center of the middle region mz to the edge of the middle region mz, along the arrangement direction of the first zones m11 and the second zones m12, the size of the previous second passivation contact layer 1301q on the second zone m12 is greater than the size of the subsequent second passivation contact layer 1301q on the second zone m12. That is, the previous second size h2q is greater than the subsequent second size h2q from the center of the middle region mz to the edge of the middle region mz. The sizes of the second passivation contact layers 1301q on the second zones m12 in the second direction F2 are decreased sequentially from the first side of the edge region mb to the second side of the edge region mb.

Therefore, the occupied space of the carrier collection region can be reduced gradually along the edge extension direction, which is beneficial to increasing the ratio of the field passivation region, thereby gradually enhancing the field effect passivation, electric leakage suppression and composite protection capabilities of the edge region mb, and improving the parallel resistance and electrical performance stability of the cell. Meanwhile, since the sizes of the second passivation contact layers 1301q on the second zones m12 along the second direction F2 are sequentially reduced, a stress region of a layer interface can be gradually changed steadily, so that the stress distribution at the edge region mb is more uniform, and the mechanical stability and structural reliability of the cell are improved.

In some embodiments of the present invention, with continued reference to FIG. 2 and FIG. 19, on the middle region mz, along the arrangement direction of the first zones m11 and the second zones m12, the sizes of the second passivation contact layers 1301k on the second zones m12 are the same. That is, the second sizes h2k corresponding to the second passivation contact layers 1301k on the second zones m12 on the middle region mz are the same. Certainly, in the case illustrated in FIG. 20 and FIG. 21, the second passivation contact layers 1301m on the second zones m12 have the same size (i.e., the same second size h2m), and the second passivation contact layers 1301n on the second zones m12 have the same size (i.e., the same second size h2n).

In this way, the second passivation contact layers 1301k on the second zones m12 on the middle region mz can be more uniformly distributed, thereby improving the current uniformity and photoelectric conversion stability of the cell. Meanwhile, the structure with a uniform size is more beneficial to process control.

In some embodiments of the present invention, with continued reference to FIG. 2 and FIG. 22, on the middle region mz, along the arrangement direction of the first zones m11 and the second zones m12, the second passivation contact layers 1301p on the second zones m12 have multiple sizes, and the sizes of adjacent two second passivation contact layers 1301p on the second zones m12 are different. That is, the second sizes h2p corresponding to two second passivation contact layers 1301p on the second zones m12 adjacent along the second direction F2 are different. In FIG. 7, the second sizes h2p corresponding to two second passivation contact layers 1301p on the second zones m12 adjacent along the second direction F2 are also different.

Therefore, the size of the second passivation contact layer 1301p on the second zone m12 can be finely and differentially adjusted according to the defect distribution, combination strength, light transmission requirements and carrier transport capabilities of different positions on the middle region mz, local electrical characteristics can be flexibly matched, carrier collection, passivation protection and local optimal distribution of light transmission areas are realized, and the overall electrical performance uniformity and photoelectric conversion efficiency at the middle region mz are improved.

It should be noted that, in the above illustrated embodiment of the change trend of the size of the second passivation contact layer on the second zone m12 on the middle region mz along the second direction F2, the change trend of the size of the first passivation contact layer on the middle region mz along the second direction F2 may also be implemented by referring to the change trend of the size of the first passivation contact layer on the edge region mz along the second direction F2, which is not repeated herein. In some embodiments, FIG. 22 illustrates the same sizes of the first passivation contact layers 120p on the middle region mz in the second direction F2 (i.e., the first sizes hlp), and FIG. 23 illustrates the same sizes of the first passivation contact layers 120q on the middle region mz in the second direction F2 (i.e., the first sizes h1q). Certainly, the sizes of the first passivation contact layers 120m on the middle region mz in the second direction F2 (i.e., the first sizes h1m) may also have a corresponding change trend as illustrated in FIG. 20.

In some embodiments, the size of the first electrode on the middle region mz along the second direction F2 and the size of the second electrode on the middle region mz along the second direction F2 may also be implemented and understood with reference to the size of the first electrode on the edge region mb along the second direction F2 and the size of the second electrode on the edge region mb along the second direction F2. For example, the change trend of the size of the first electrode on the middle region mz along the second direction F2 may be the same as the change trend of the size of the first passivation contact layer on the middle region mz along the second direction F2; the change trend of the size of the second electrode on the middle region mz along the second direction F2 may be the same as the change trend of the size of the second passivation contact layer on the second zone m12 on the middle region mz along the second direction F2. For another example, the size of the first electrode on the middle region mz along the second direction F2 may be the same as the size of the first electrode on the edge region mb along the second direction F2; the size of the second electrode on the middle region mz along the second direction F2 may be the same as the size of the second electrode on the edge region mb along the second direction F2. Details are not repeated herein.

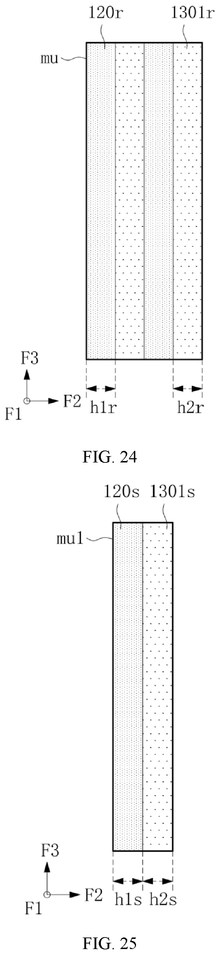

In some embodiments of the present invention, with reference to FIG. 24, which is a schematic diagram of the first passivation contact layer 120r and the second passivation contact layer 1301r on the second zone m12 on a unit region mu. In some embodiments of the present invention, the first surface m1 includes a plurality of unit regions mu. The unit region mu includes at least one first zone m11 and at least one second zone m12. On the same unit region mu, along the arrangement direction of the first zones m11 and the second zones m12, the size of the first passivation contact layer 120r is equal to the size of the second passivation contact layer 130r located on the second zone m12.

The unit region mu refers to a basic functional unit constructed by at least one first zone m11 and at least one second zone m12 together in the cell structure.

In some embodiments, FIG. 24 illustrates a case where the unit region mu includes two first zones m11 and two second zones m12, and the first size h1r and the second size h2r are equal. In some embodiments, taking FIG. 25 as an example, FIG. 25 is a schematic diagram of the first passivation contact layer 120s and the second passivation contact layer 1301s on the second zone m12 on the unit region mu1. In some other embodiments of the present invention, and illustrates a case where the unit region mu1 includes one first zone m11 and one second zone m12, and the first size h1s is equal to the second size h2s. Certainly, the unit region may also include other numbers of first zones m11 and other numbers of second zones m12, which is not limited herein.

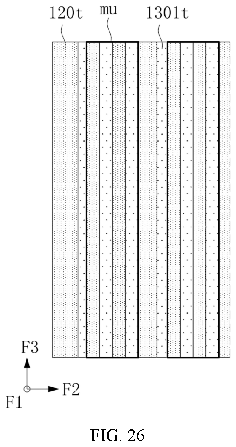

With continued reference to FIG. 24 in conjunction with FIG. 26, which is a schematic diagram of cooperation of the unit region mu and a non-unit region. In some other embodiments of the present invention, and adjacent two unit regions mu are spaced apart along the arrangement direction of the first zones m11 and the second zones m12.

Thus, the passivation protection function and the carrier collection function are more evenly distributed in the unit region mu to improve cell output stability. The adjacent unit regions mu are spaced apart, so that the unit regions mu are independent of each other and are not overlapped, and the spacing between the adjacent unit regions mu provides a providing space for other first passivation contact layers 120t and other second passivation contact layers 1301t on the second zones m12 which have different sizes. Meanwhile, the arrangement of the plurality of unit regions mu is beneficial to improving the stress uniformity of the layer interface, and lowering the risk of local stress concentration, thereby improving the mechanical stability and the long-term reliability of the cell.

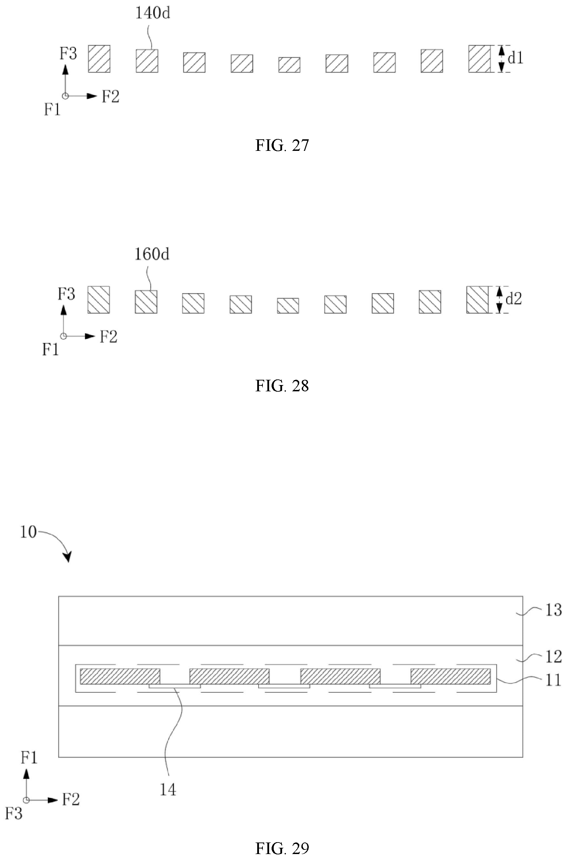

In some embodiments of the present invention, with continued reference to FIG. 2 in conjunction with FIG. 27, which is a schematic diagram of an arrangement of the first electrodes 140d. In some embodiments of the present invention, the heights of the first electrodes 140d gradually increase from the middle region mz to the edge region mb.

The height of the first electrode 140d is the size of the first electrode 140d along the third direction F3, i.e., a first height d1. The gradually increasing can be understood by referring to the situation illustrated in some foregoing embodiments, and is not repeated herein.

As such, it is conducive to improving the conductive and contact reliability on the region closer to the edge, but also conducive to enhancing the strength and stability at the region closer to the edge.

In some embodiments of the present invention, with continued reference to FIG. 2 and FIG. 27, from the middle region mz to the edge region mb, the height of the previous first electrode 140d is less than that of the subsequent first electrode 140d. That is, the heights of the first electrodes 140d are increased in sequence from the middle region mz to the edge region mb.

Therefore, the conductivity of the electrode can be improved gradually, and the risk of cell damage caused by larger stress of the edge region mb can be reduced.

In some embodiments of the present invention, with continued reference to FIG. 27, the height of the first electrode 140d ranges from 8µm to 15µm.

In some embodiments, the first height d1 may be 8µm, 9µm, 10µm, 11µm, 12µm, 13µm, 14µm, or 15µm. Certainly, the first height d1 may also be any other value within the range from 8µm to 15µm, and is not limited herein.

Therefore, the first electrode 140d can have certain conductivity, and it is conducive to improving the mechanical strength of the first electrode 140d, so as to improve the reliability of the edge region mb.

In some embodiments of the present invention, with continued reference to FIG. 2 in conjunction with FIG. 28, which is a schematic diagram of an arrangement of the second electrodes 160d. In some embodiments of the present invention, the heights of the second electrodes 160d gradually increase from the middle region mz to the edge region mb.

The height of the second electrode 160d is the size of the second electrode 160d along the third direction F3, i.e., a second height d2. The gradually increasing can be understood by referring to the situation illustrated in some foregoing embodiments, and is not repeated herein.

As such, it is conducive to improving the conductive and contact reliability on the region closer to the edge, but also conducive to enhancing the strength and stability at the region closer to the edge.

In some embodiments of the present invention, with continued reference to FIG. 2 and FIG. 28, from the middle region mz to the edge region mb, the height of the previous second electrode 160d is less than that of the subsequent second electrode 160d. That is, the heights of the second electrodes 160d are increased in sequence from the middle region mz to the edge region mb.

Therefore, the conductivity of the electrode can be improved gradually, and the risk of cell damage caused by larger stress of the edge region mb can be reduced.

In some embodiments of the present invention, with continued reference to FIG. 28, the height of the second electrode 160d ranges from 8µm to 15µm.

In some embodiments, the second height d2 may be 8µm, 9µm, 10µm, 11µm, 12µm, 13µm, 14µm, or 15µm. Certainly, the second height d2 may also be any other value within the range from 8µm to 15µm, and is not limited herein.

Therefore, the second electrode 160d can have certain conductivity, and it is conducive to improving the mechanical strength of the second electrode 160d, so as to improve the reliability of the edge region mb.

Referring to FIG. 29, which is a schematic structural diagram of a photovoltaic module 10 according to some embodiments of the present invention, and some embodiments of the present invention provide a photovoltaic module 10, including a cell string 11, a packaging layer 12, and a cover plate 13. The packaging layer 12 is configured to cover a surface of the cell string 11, and the cover plate 13 is configured to cover a surface of the packaging layer 12 away from the cell string 11. The cell string 11 is formed by connecting a plurality of back contact cells according to any one of the above embodiments.

Further, the back contact cells are electrically connected in a monolithic or plural-segment form to form the plurality of cell strings 11, and the plurality of cell strings 11 are electrically connected in series and/or in parallel.

In some embodiments, the plural cell strings 11 may be electrically connected by conductive strips 14. The packaging layer 12 covers front and back surfaces of the back contact cell.

In some embodiments, the packaging layer 12 may be an organic packaging adhesive film such as an ethylene vinyl acetate (EVA) adhesive film, a polyolefin elastomer (POE) adhesive film, or a polyethylene terephthalate (PET) adhesive film.

In some embodiments, the cover plate 13 may be a glass cover plate, a plastic cover plate, or the like, having a light transmitting function.

In some embodiments, a surface of the cover plate 13 facing the packaging layer 12 may be a concave-convex surface, so as to increase a utilization rate of incident light.

The advantages of the above back contact cell are also provided for the photovoltaic module 10, and are not repeated herein.

## Claims

1. A back contact cell (100), comprising:
a substrate (110) having a first surface (m1), the first surface (m1) defining a plurality of first zones (m11) and a plurality of second zones (m12) that are alternately arranged;
a plurality of first passivation contact layers (120) comprising a plurality of tunneling layers (121) and a plurality of first doped layers (122), the tunneling layers (121) being provided on the first zones (m11), and the first doped layers (122) being provided on sides of the tunneling layers (121) away from the substrate (110); and
a plurality of second passivation contact layers (130) comprising a plurality of amorphous material layers (131) and a plurality of second doped layers (132), the amorphous material layers (131) being at least provided on the second zones (m12), and the second doped layers (132) being provided on sides of the amorphous material layers (131) away from the substrate (110);
wherein along an arrangement direction of the first zones (m11) and the second zones (m12), the first surface (m1) defines a middle region (mz) and two edge regions (mb) located on two sides of the middle region (mz); a part of the first zones (m11) and a part of the second zones (m12) are located in the middle region (mz), and another part of the first zones (m11) and another part of the second zones (m12) are located in the edge regions (mb); on at least one edge region (mb), along the arrangement direction of the first zones (m11) and the second zones (m12), a total size of the first passivation contact layers (120) is greater than a total size of the second passivation contact layers (130) located on the second zones (m12).

2. The back contact cell (100) according to claim 1, wherein along the arrangement direction of the first zones (m11) and the second zones (m12), a ratio of a size of the edge region (mb) to a size of the middle region (mz) is 0.2 to 1; or
wherein along the arrangement direction of the first zones (m11) and the second zones (m12), the size of the edge region (mb) is 0.3mm to 20mm, and the size of the middle region (mz) is 65mm to 190mm; or
wherein on the same edge region (mb), along the arrangement direction of the first zones (m11) and the second zones (m12), a ratio q1 of the total size of the first passivation contact layers (120) to the total size of the second passivation contact layers (130) located on the second zones (m12) satisfies: 1<q1≤ 2; or
wherein on the same edge region (mb), along the arrangement direction of the first zones (m11) and the second zones (m12), a ratio q2 of a size of the first passivation contact layer (120) to a size of the second passivation contact layer (130) located on the second zone (m12) satisfies: 1≤q2≤2; or
wherein on the edge region (mb), along the arrangement direction of the first zones (m11) and the second zones (m12), the size of the first passivation contact layer (120) is 200µm to 1000µm, and the size of the second passivation contact layer (130) located on the second zone (m12) is 100µm to 500µm.

3. The back contact cell (100) according to claim 1 or 2, wherein the edge region (mb) has a first side connected to the middle region (mz) and a second side arranged opposite to the first side; on the same edge region (mb), from the first side to the second side, along the arrangement direction of the first zones (m11 and the second zones (m12), the sizes of the first passivation contact layers (120) gradually increase.

4. The back contact cell (100) according to claim 3, further comprising a plurality of first electrodes (140) arranged on sides of the first doped layers (122) away from the tunneling layers (121) and electrically connected to the first doped layers (122);
wherein on the same edge region (mb), from the first side to the second side, along the arrangement direction of the first zones (m11) and the second zones (m12), sizes of the first electrodes (140) gradually increase; or
wherein on the same edge region (mb), from the first side to the second side, along the arrangement direction of the first zones (m11) and the second zones (m12), a size of a previous first electrode (140) located on the first zone (m11) is less than a size of a subsequent first electrode (140) located on the first zone (m11); or
wherein on the same edge region (mb), along the arrangement direction of the first zones (m11) and the second zones (m11), the sizes of the first electrodes (140) range from 30µm to 70µm.

5. The back contact cell (100) according to any one of claims 1 to 4, wherein the edge region (mb) has a first side connected to the middle region (mz) and a second side arranged opposite to the first side; on the same edge region (mb), from the first side to the second side, along the arrangement direction of the first zones (m11) and the second zones (m12), the sizes of the first passivation contact layers (120) gradually decrease.

6. The back contact cell (100) according to claim 5, wherein on the same edge region (mb), from the first side to the second side, along the arrangement direction of the first zones (m11) and the second zones (m12), a size of a previous first passivation contact layer (120) is greater than a size of a subsequent first passivation contact layer (120).

7. The back contact cell (100) according to claim 5, further comprising a plurality of first electrodes (140) arranged on sides of the first doped layers (122) away from the tunneling layers (121) and electrically connected to the first doped layers (122);
wherein on the same edge region (mb), from the first side to the second side, along the arrangement direction of the first zones (m11) and the second zones (m12), sizes of the first electrodes (140) gradually decrease;
or wherein on the same edge region (mb), from the first side to the second side, along the arrangement direction of the first zones (m11) and the second zones (m12), a size of a previous first electrode (140) located on the first zone (m11) is greater than a size of a subsequent first electrode (140) located on the first zone (m11); or
wherein on the same edge region (mb), along the arrangement direction of the first zones (m11) and the second zones (m12), the sizes of the first electrodes (140) range from 30µm to 70µm.

8. The back contact cell (100) according to claim any one of claims 1 to 7, wherein the edge region (mb) has a first side connected to the middle region (mz) and a second side arranged opposite to the first side; on the same edge region (mb), from the first side to the second side, along the arrangement direction of the first zones (m11) and the second zones (m12), the sizes of the second passivation contact layers (130) located on the second zones (m12) gradually increase.

9. The back contact cell (100) according to claim 8, wherein on the same edge region (mb), from the first side to the second side, along the arrangement direction of the first zones (m11) and the second zones (m12), a size of a previous second passivation contact layer (130) located on the second zone (m12) is less than a size of a subsequent second passivation contact layer (130) located on the second zone (m12).

10. The back contact cell (100) according to claim 8, further comprising a plurality of second electrodes (160) arranged on sides of the second doped layers (132) away from the amorphous material layers (131) and electrically connected to the second doped layers (132);
wherein on the same edge region (mb), from the first side to the second side, along the arrangement direction of the first zones (m11) and the second zones (m12), sizes of the second electrodes (160) gradually increase; or
wherein on the same edge region (mb), from the first side to the second side, along the arrangement direction of the first zones (m11) and the second zones (m12), a size of a previous second electrode (160) located on the second zone (m12) is less than a size of a subsequent second electrode (160) located on the second zone (m12); or
wherein on the same edge region (mb), along the arrangement direction of the first zones (m11) and the second zones (m12), the sizes of the second electrodes (160) range from 30µm to 70µm.

11. The back contact cell (100) according to claim any one of claims 1 to 10, wherein the edge region (mb) has a first side connected to the middle region (mz) and a second side arranged opposite to the first side; on the same edge region (mb), from the first side to the second side, along the arrangement direction of the first zones (m11) and the second zones (m12), the sizes of the second passivation contact layers (130) located on the second zones (m12) gradually decrease.

12. The back contact cell (100) according to claim 11, wherein on the same edge region (mb), from the first side to the second side, along the arrangement direction of the first zones (m11) and the second zones (m12), a size of a previous second passivation contact layer (130) located on the second zone (m12) is greater than a size of a subsequent second passivation contact layer (130) located on the second zone (m12).

13. The back contact cell (100) according to claim 11, further comprising a plurality of second electrodes (160) arranged on sides of the second doped layers (132) away from the amorphous material layers (131) and electrically connected to the second doped layers (132);
wherein on the same edge region (mb), from the first side to the second side, along the arrangement direction of the first zones (m11) and the second zones (m12), sizes of the second electrodes (160) gradually decrease; or
wherein on the same edge region (mb), from the first side to the second side, along the arrangement direction of the first zones (m11) and the second zones (m12), a size of a previous second electrode (160) located on the second zone (m12) is greater than a size of a subsequent second electrode (160) located on the second zone (m12); and/or
on the same edge region (mb), along the arrangement direction of the first zones (m11) and the second zones (m12), the sizes of the second electrodes (160) range from 30µm to 70µm.

14. The back contact cell (100) according to any one of claims 1 to 13, wherein on the middle region (mz), along the arrangement direction of the first zones (m11) and the second zones (m12), a total size of the first passivation contact layers (120) is less than a total size of the second passivation contact layers (130) located on the second zones (m12).

15. A photovoltaic module (10), comprising:
a cell string (11);
a packaging layer (12) configured to cover a surface of the cell string (11); and
a cover plate (13) configured to cover a surface of the packaging layer (12) away from the cell string (11);
wherein the cell string (11) is formed by connecting a plurality of back contact cells (100) according to claims 1 to 14.
